# EUROPEAN PATENT APPLICATION

(11) **EP 4 704 499 A1**
(43) Date of publication of application: **04.03.2026**
(21) Application number: 24198049.9
(22) Date of filing: 03.09.2024
(51) Int. Cl.: H05K 3/40, H05K 3/46, H01L 23/538, H05K 1/02, H05K 1/03, H05K 1/18

(54) **COMPONENT CARRIER WITH INORGANIC CARRIER HAVING INSERTED PIN DIRECTLY ENCAPSULATED IN THROUGH HOLE**

(71) Applicant: AT&S Austria Technologie & Systemtechnik Aktiengesellschaft, 8700 Leoben (AT)
(72) Inventor: Lee, Eung Suk, 8700 Leoben (AT); Park, Ho Sik, Chongqing, 401120 (CN); Mok, Jee Soo, 8700 Leoben (AT)
(74) Representative: Dilg, Haeusler, Schindelmann Patentanwaltsgesellschaft mbH

(57) **Abstract**

A component carrier (100) which comprises a stack (102) comprising at least one electrically conductive layer structure (104) and at least one electrically insulating layer structure (106), an inorganic carrier (108) provided as part of the stack (102), wherein said inorganic carrier (108) has a first main surface (110) and an opposing second main surface (112), a through hole (114) in the inorganic carrier (108) extending between the first main surface (110) and the second main surface (112), and at least one at least partially conductive pin (116) in said through hole (114), wherein said at least one at least partially conductive pin (116) is directly encapsulated in the through hole (114) by encapsulating material (118) of at least one electrically insulating layer structure (106) of the stack (102).

## Description

### Field of the Invention

The invention relates to a component carrier, and to a method of manufacturing a component carrier.

### Technological Background

In the context of growing product functionalities of component carriers equipped with one or more components and increasing miniaturization of such components as well as a rising number of components to be connected to the component carriers such as printed circuit boards or component carriers, increasingly more powerful array-like components or packages having several components are being employed, which have a plurality of contacts or connections, with smaller and smaller spacing between these contacts. In particular, component carriers shall be mechanically robust and electrically reliable so as to be operable even under harsh conditions.

Conventional approaches of forming component carriers are still challenging.

### Summary of the Invention

There may be a need to form a compact and reliable component carrier.

According to an exemplary embodiment of the invention, a component carrier is provided which comprises a stack comprising at least one electrically conductive layer structure and at least one electrically insulating layer structure, an inorganic carrier provided as part of the stack, wherein said inorganic carrier has a first main surface and an opposing second main surface, a through hole in the inorganic carrier extending between the first main surface and the second main surface, and at least one at least partially conductive pin in said through hole, wherein said at least one at least partially conductive pin is directly encapsulated in the through hole by encapsulating material of at least one electrically insulating layer structure of the stack.

According to another exemplary embodiment of the invention, a method of manufacturing a component carrier is provided, wherein the method comprises providing a stack comprising at least one electrically conductive layer structure and at least one electrically insulating layer structure, providing an inorganic carrier as part of the stack, wherein said inorganic carrier has a first main surface and an opposing second main surface, forming a through hole in the inorganic carrier extending between the first main surface and the second main surface, inserting at least one at least partially conductive pin in said through hole, and directly encapsulating said at least one at least partially conductive pin in the through hole by encapsulating material of at least one electrically insulating layer structure of the stack.

In the context of the present application, the term "component carrier" may particularly denote any support structure which is capable of accommodating one or more components thereon and/or therein for providing mechanical support and/or electrical connectivity and/or thermal connectivity. In other words, a component carrier may be configured as a mechanical and/or electronic and/or thermal carrier for components. A component carrier may comprise a laminated stack, such as a laminated layer stack. In particular, a component carrier may be one of a printed circuit board, an organic interposer, and an IC (integrated circuit) substrate. A component carrier may also be a hybrid board combining different ones of the above mentioned types of component carriers.

In the context of the present application, the term "stack" may particularly denote a flat or planar sheet-like body. For instance, the stack may be a layer stack, in particular a laminated layer stack or a laminate. Such a laminate may be formed by connecting a plurality of layer structures by the application of mechanical pressure and/or heat. Preferably, the plurality of layer structures are aligned parallel on top of each other. The stack may comprise at least one electrically conductive structure and at least one electrically insulating structure.

In the context of the present application, the term "layer structure" may particularly denote a continuous layer, a patterned layer or a plurality of nonconsecutive islands within a common plane, and it may perform the function of electrical conductivity and/or electrical insulation. A layer structure may also comprise an interconnection structure which protrudes from a planar surface of the layer structure.

In the context of the present application, the term "inorganic carrier body" may particularly denote a carrier structure which comprises inorganic material. In particular, dielectric material of the inorganic carrier body or even the entire inorganic carrier body may be made exclusively or at least substantially exclusively from inorganic material. In another embodiment, the inorganic carrier body may comprise inorganic dielectric material and additionally another dielectric material and/or other inorganic material. An inorganic compound may be a chemical compound that lacks carbon-hydrogen bonds or a chemical compound that is not an organic compound. Examples of inorganic carrier body materials are glass (in particular silicon-based glass), a ceramic (such as aluminum nitride and/or aluminum oxide), and a material comprising a semiconductor (such as silicon oxide, silicon, silicon carbide, gallium nitride, etc.). In an example, the inorganic carrier body may comprise semiconductor material, for example silicon and/or germanium and/or silicon oxide and/or germanium oxide and/or silicon carbide and/or gallium nitride. In a further embodiment, the inorganic layer structure may comprise (in particular elemental) metal and/or one or more metal alloys, for example, copper and/or tin and/or brass. Yet in another embodiment, the inorganic layer structure may comprise inorganic material, which is not listed in the above mentioned examples, such as: MoS2, CuGaD2, AgAlO2, LiGaTe2, AgInSe2, CuFeS2, BeO. In an example, the inorganic carrier structure may have a thickness larger than 30 µm. Additionally or alternatively, the inorganic carrier structure may have a thickness smaller than 1.2 mm.

In the context of the present application, the term "through hole in the inorganic carrier" may particularly denote a hollow volume extending a complete path between two opposing main surfaces of the inorganic carrier. For example, the through hole may be a single vertical through hole or a single slanted through hole. The through hole may also be composed of a plurality of connected subsections. For instance, the through hole may have vertical sidewalls, may be tapering, or may have an hourglass shape (i.e. may be formed by two connected subsections tapering in opposite directions).

In the context of the present application, the term "at least partially conductive pin" may particularly denote a body (preferably an elongate body, such as a pillar, post or stick) made of an electrically and/or thermally conductive material. For instance, the pin may be metallic (for instance may comprise copper and/or aluminum). It is also possible that the pin is made of a ceramic material (such as aluminum nitride or aluminum oxide) being highly thermally conductive, for instance having a thermal conductivity of at least 50 W/mK. The pin may comprise magnetic material. Preferably, a metallic material and a magnetic material may be mixed together or magnetic material may coat a surface of a metallic material. Such kind of composition of the conductive pin, may provide an inductive property to the component carrier. Preferably, but not necessarily, the pin may have a length being larger than a diameter. For instance, a ratio between a length and a diameter of the pin may be at least 2. The pin may be an inlay. Such an inlay may be pre-formed and may be inserted into the through hole as a whole. This distinguishes the pin from a plating structure formed in the through hole by plating. As an electrically conductive structure in the through hole of inorganic carrier body, a conventional plating structure may be difficult to be plated in the through hole with a good filling. Hence, the pin may be a separate or additional component, rather than being integrally formed in through holes of an inorganic carrier. Therefore, placing the conductive pin in the through hole of the inorganic carrier body may overcome the drawback of a conventional plating structure in the through hole of the inorganic carrier body and may also decrease the manufacturing effort since the effort for a plating process and the effort for providing a plating structure is quite high.

In the context of the present application, the term "the at least partially conductive pin is directly encapsulated in the through hole by encapsulating material of at least one electrically insulating layer structure of the stack" may particularly denote that the pin is at least partially surrounded with direct physical contact by dielectric material belonging to one or more electrically insulating layer structures of the stack, for instance belonging to a dielectric sheet attached to the inorganic carrier. For instance, such a dielectric material may be connected with a pin surface by lamination of an electrically insulating layer structure onto the inorganic carrier, i.e. by the application of elevated temperature and/or pressure. For instance, a still curable resin of an electrically insulating layer structure of the stack may become flowable under the influence of elevated temperature and/or pressure and may therefore flow into gaps between the pin and a circumferentially closed hole in the inorganic carrier delimiting the through hole. After curing (for instance by polymerizing and/or cross-linking), the resin may re-solidify for forming solid encapsulating material in direct physical contact with at least part of a lateral surface of the pin. The encapsulant material directly encapsulating at least part of the pin may be embodied as a resin which has flown around the pin during lamination. And with such a process, the pin and the encapsulant material may have a good adhesion without the risk of delamination.

In an embodiment, a layer of an adhesion promoter is located between the dielectric material of the electrically insulating layer structure and the inorganic carrier body.

In the context of the present application, the term "main surface" of a body may particularly denote one of two largest opposing surfaces of the body or outermost opposing surfaces of the body. The main surfaces may be connected by circumferential side walls. The thickness of a body, such as the inorganic carrier, may be defined by the distance between the two opposing main surfaces.

According to an exemplary embodiment of the invention, a component carrier (such as a printed circuit board or an integrated circuit substrate) has a (for instance laminated) layer stack. Said stack may comprise an inorganic carrier (such as a glass plate) having one or more through holes extending through the entire inorganic carrier. Advantageously, one or more (preferably pre-formed inlay-type) pins may be inserted in each of said one or more through holes. Preferably, said pin may be electrically and/or thermally conductive. For example, said pin may comprise or consist of a metallic material such as copper. Thus, during operation of the component carrier, the at least partially conductive pin may conduct electricity and/or thermal energy. Beneficially, the one or more pins may be directly encapsulated in an interior of the through hole in the inorganic carrier by encapsulating material which originates from an electrically insulating layer structure of the stack. For instance, such an encapsulating material may flow from the electrically insulating layer structure during lamination onto the inorganic carrier into the through hole for covering the pin with direct physical contact and may then become (preferably permanently) solid. By taking this measure, a reliable conductive connection may be established between two opposing main surfaces of an inorganic carrier by the one or conductive pins. At the same time, the pin(s) may be reliably fixed in place by the surrounding encapsulating material. By inserting the one or more pins in the respective one more through holes (rather than forming conductive material by plating or the like in the through hole), insufficient filling of the through hole with conductive material (for instance the formation of voids during plating) may be reliably prevented. This may hold especially for products with high aspect ratio of through holes, which may suffer from difficulties to complete fill the holes (in particular when a through hole height is more than 500 µm and/or the aspect ratio is bigger than 8), so that the electrical connection issue resulting from the insufficient filling can be suppressed or even eliminated. At the same time, the use of a stack dielectric for directly encapsulating the pin in the through hole of the inorganic carrier may render the manufacturing process simple and reliable. Moreover, warpage control may be significantly improved by exemplary embodiments since the pin design may be adapted for suppressing warpage. Advantageously, the pin height and/or thickness can be changed and formed based on the criteria or the calculation for coefficient of thermal expansion (CTE) distribution by differentiating the density of the whole component carriers to balance the redistribution layer (RDL) on one side and the layers on the other side of the inorganic carrier body regarding the warpage control compared with the through hole plating structure. Filling the pin in the through hole can also avoid the delamination between the plating structure in the hole and the surface of the inorganic through hole, and it can also avoid crack of the inorganic material. Furthermore, the insertion of a pre-formed inlay-type pin into a through hole of an inorganic carrier may allow to separately adjust the characteristics of the pin and a thickness of a patterned metallic layer of the stack. Therefore, this also can make an asymmetric structure of the component carrier behave like a symmetric structure to reduce the CTE mismatch issue.

### Detailed Description of Exemplary Embodiments

In the following, further exemplary embodiments of the component carrier and the method will be explained.

In an embodiment, the at least one at least partially conductive pin comprises at least a portion that is electrically conductive, in particular the whole pin is electrically conductive. During operation of the component carrier, a respective conductive pin may be configured for fulfilling an electric functionality, for instance transmitting an electric signal and/or electric energy. In one embodiment, the conductive pin is completely electrically conductive, for instance consists of a metal such as copper. In other embodiments, the conductive pin comprises a metal such as copper and comprises an electrically insulating portion, for instance a thermally or electrically insulating shell around a conductive core. The conductive pin may also comprise a magnetic portion (like a magnetic coating film coated on the surface of the conductive pin), so the structure may provide a function of an inductor in the component carrier. Thus, it may be possible to reduce the electromagnetic interference to make the signal path smoother and less blocking, and it also can store power. Additionally, this may also allow to regulate the voltage and/or the current by change of the inductance.

In an embodiment, the at least one at least partially conductive pin comprises two extremities (such as opposing ends) at least one of which (preferably both) being aligned (or being in flush) with an assigned one of the first main surface and the second main surface of the inorganic carrier. In this context, "aligned" or "flush with" may denote that a lower end of the conductive pin is arranged at the same vertical level as the first main surface of the inorganic carrier and/or that an upper end of the conductive pin is arranged at the same vertical level as the second main surface of the inorganic carrier. This may lead to a compact and symmetric design of the component carrier and may make the dielectric layer have a better uniformity when it is laminated on the surface. It may be beneficial of fine structuring and good alignment between layers, which may help to manufacture a product with better quality and reliability.

In an embodiment, the at least one at least partially conductive pin comprises two extremities at least one of which (preferably both) being misaligned (or being not in flush) with an assigned one of the first main surface and the second main surface of the inorganic carrier. In this context, "misaligned" or "not in flush" may denote that a lower end of the conductive pin is protruding beyond or is retracted with respect to the vertical level of the first main surface of the inorganic carrier and/or that an upper end of the conductive pin is protruding beyond or is retracted with respect to the vertical level of the second main surface of the inorganic carrier. This may lead to an intentionally asymmetric design of the pin with respect to the inorganic carrier which may at least partially compensate warpage phenomena resulting from an asymmetric design of other layer structures on both opposing main surfaces of the inorganic carrier. For instance, a redistribution layer or structure may be arranged only on one main surface of the inorganic carrier, which may cause an asymmetry of the component carrier as a whole. This may lead, in turn, to warpage. By an intentional misalignment of the one or more at least partially conductive pins, such an asymmetry may be compensated partially or entirely for reducing or eliminating warpage. To put it shortly, a misaligned arrangement of the at least partially conductive pins with respect to the inorganic carrier may be designed in such a way so as to increase the homogeneity of the metal distribution over the volume of the component carrier.

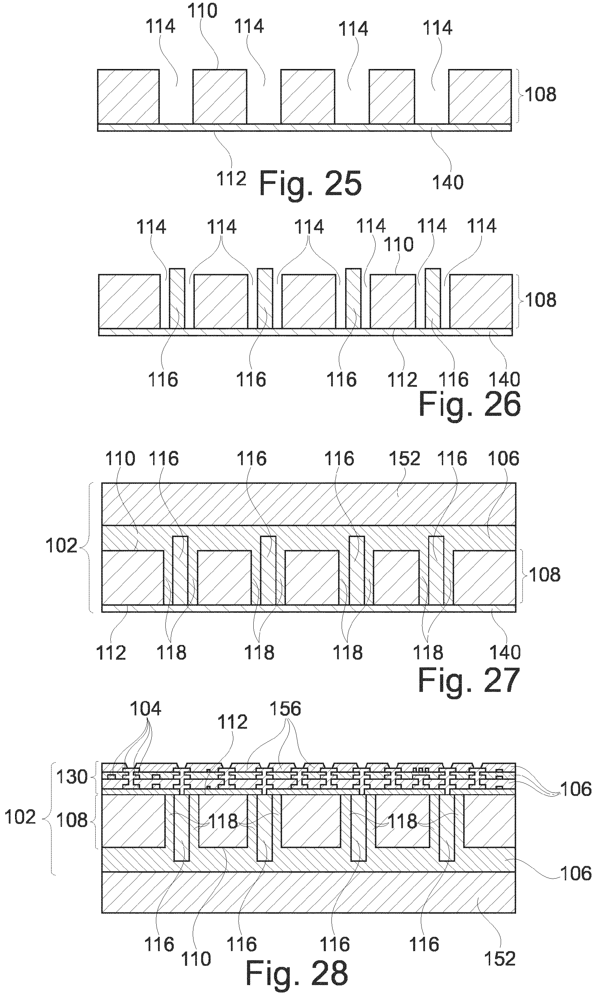

In an embodiment, the at least one at least partially conductive pin comprises a first extremity being aligned with an assigned one of the first main surface and the second main surface of the inorganic carrier and comprises a second extremity being misaligned with the other one of the first main surface and the second main surface of the inorganic carrier. Such an embodiment is shown in Figure 26 and is one example of rendering a metal distribution in a component carrier more symmetric. The protrusion of the conductive pin on one side of the inorganic carrier body can compensate the thickness of layers with the layers on the other side of the inorganic carrier, therefore it can be more symmetric to control the warpage.

In an embodiment, the protrusion is designed to be an interconnection structure, as a pillar. The encapsulation material may be solder resist material. Then, the pillar can be exposed with surface finish treatment, and may be able to connect to a component directly.

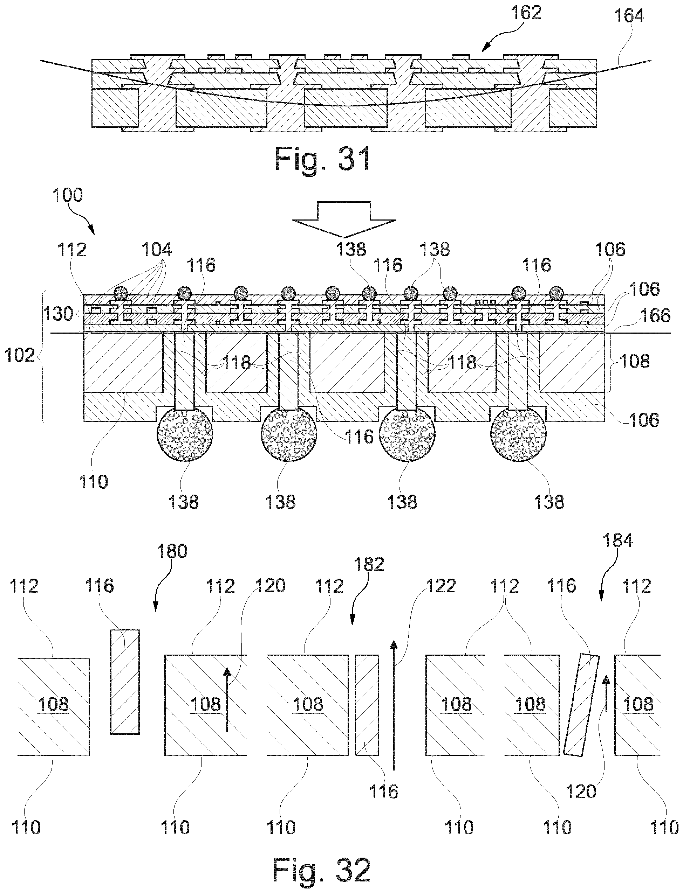

In an embodiment, the at least one at least partially conductive pin is misaligned with respect to a thickness direction of the stack. Such an embodiment is shown in Figure 32 on the left-hand side and is one example of rendering a metal distribution in a component carrier more symmetric.

In an embodiment, the at least one at least partially conductive pin is misaligned by being tilted or inclined with respect to the thickness direction of the stack. Such an embodiment is shown in Figure 32 on the right-hand side and is one example of rendering a metal distribution in a component carrier more symmetric.

In an embodiment, the conductive pin is centered in the through hole with good accuracy. Achieving such accuracy may provide a good alignment among all the conductive pins and it can also have a good alignment with the pattern of next layers. This may provide a proper signal integrity and may also achieve a good yield of product manufacturing.

In an embodiment, the at least one at least partially conductive pin is misaligned with respect to the through hole. For instance, the respective pin may be arranged asymmetrically within the assigned through hole.

In an embodiment, the at least one at least partially conductive pin is misaligned by being laterally displaced with respect to a central axis of the through hole. Such an embodiment is shown in Figure 32 in the middle and is one example of rendering a metal distribution in a component carrier more symmetric.

In an embodiment, the at least one at least partially conductive pin is misaligned by providing a larger amount of encapsulating material between one delimiting sidewall of the through hole and the at least one at least partially conductive pin in comparison with a smaller amount of encapsulating material between another delimiting sidewall of the through hole and the at least one at least partially conductive pin. For instance, more encapsulating material may be arranged on one lateral side of the pin compared with its opposing other lateral side. Additionally or alternatively, more encapsulating material may be arranged in an upper region of the pin compared with its lower region, or vice versa. This encapsulant inhomogeneity may be used as a further design parameter which may also contribute to the suppression of warpage. With such kind of design, the different volume of encapsulant can adjust the CTE of different areas to compensate at least partially the CTE mismatch, so that the warpage can be suppressed as well.

In an embodiment, a plurality of through holes are provided in the inorganic carrier each extending between the first main surface and the second main surface and each having at least one at least partially conductive pin in the respective through hole, wherein a first distance between two opposing extremities of a first one of the conductive pins is different from a second distance between two opposing extremities of a second one of the conductive pins. For instance, the pins may be arranged side-by-side, along one direction, or in a matrix like manner. Different pins in different through holes of the same inorganic carrier may have a different vertical length. By adjusting the lengths of different conductive pins differently, an asymmetric metal distribution over the extension of the component carrier may also be influenced for improving warpage management.

In an embodiment, the value of the difference between the first distance and the second distance divided by the value of the first distance is in a range from 1% to 20%, in particular from 5% to 10%. Thus, an absolute value between the first distance and the second distance divided by the first distance may be in a range from 1% to 20%. Within such a tolerance, the alignment between the conductive pin and the electrically conductive structure of the next layers can be guaranteed. Therefore, it can have good yield from manufacturing point of view. Meanwhile, the electrical performance of the final product is qualified.

In an embodiment, a cross-sectional shape of the at least one at least partially conductive pin is round, for example circular, or polygonal, for example rectangular. Since the pin can be inserted in the respective through hole as an inlay, there is a complete freedom of design concerning the shape of the pin. This shape may be used as a further design parameter for fine-tuning the properties of the component carrier, in particular in terms of warpage suppression and suppression of delamination.

In an embodiment, a cross-sectional shape of the at least one at least partially conductive pin is different from a cross-sectional shape of the through hole. The cross-sectional shape of the pin may be freely adjusted in a pin manufacturing process prior to the processing of the component carrier. The cross-sectional shape of the through hole may depend on the through hole formation process. For instance, mechanically drilling the through hole may lead to a cylindrical through hole. Laser drilling may lead to a tapering through hole or an hourglass shape through hole. By adjusting the shape of the through hole, the characteristics of inserting the pins in the respective through hole may be controlled. For instance, a tapering geometry may lead to a self-centering effect, whereas straight sidewalls may provide freedom to arrange the pin asymmetrically and/or intentionally misaligned in a through hole.

In an embodiment, the at least one at least partially conductive pin comprises a conductive core having sidewalls being at least partially covered by a shell. For example, the core may be shaped as a post or pillar, whereas the shell may be shaped as a sleeve arranged around the core. While the conductive core may fulfill an electric and/or a thermal function, the sleeve may fulfill an additional function (such as electrical insulation, thermal isolation, magnetic shielding, mechanical and/or chemical protection, or providing inductance, etc.), or vice versa. Said additional function of the sleeve may protect the core (for instance electrically, thermally, magnetically, mechanically and/or chemically).

In an embodiment, the sidewalls of the core are partially covered by the encapsulating material. Thus, not only the shell, but also part of the core may be in direct physical contact with the encapsulating material. However, the core may be also partially without direct physical contact with the encapsulating material.

In an embodiment, the shell is configured as a shielding structure for providing a shielding function, for example for shielding the conductive core. Any shielding may be accomplished, for instance electrically, thermally, magnetically, mechanically and/or chemically shielding. To give one example, the shielding structure may shield an electrically conductive core (which may carry electric signals during operation of the component carrier) with respect to electromagnetic radiation (propagating from an electronic environment towards the electrically conductive pin and/or from the electrically conductive pin towards an electronic environment). By shielding such electromagnetic radiation, a failure free operation of the component carrier and/or an electronic environment thereof may be ensured. This may be advantageous for high frequency applications. The shielding can have other functions such as functioning as inductor for power storage and/or to filter a signal.

In an embodiment, the component carrier comprises a shielding structure in the through hole. This shielding structure may form part of the conductive pin or may be provided separately from the conductive pin.

In an embodiment, the shielding structure may be an encapsulant completely filling the through hole and having the same level with the pin and the surface of the inorganic carrier body. The shielding structure can be formed in advance of the insertion of the pin or can be plugged in the gap between the pin and the sidewalls of the through hole after the pin has been placed in the through hole.

In an embodiment, one or two opposing extremities of the shielding structure is or are aligned with one or two opposing main surfaces of at least one of the layer structures of the stack, for example with one or both of the first main surface and the second main surface of the inorganic carrier. Alternatively, one or two opposing extremities of the shielding structure is or are misaligned with respect to one or two opposing main surfaces of at least one of the layer structures of the stack. Thus, the shielding structure and its arrangement with respect to the inorganic carrier may be used as a further design parameter for compensating asymmetric characteristics of the component carrier.

In an embodiment, the shielding structure comprises electrically insulating material, thermally insulating material, electrically conductive material and/or magnetic material. It may be possible that the shielding structure comprises a ferromagnetic material, for example iron, copper, nickel and/or ferrite. It may also be possible that the shielding structure comprises an insulating material, for example an insulating paste, a resin, a photoimageable dielectric, a solder resist, prepreg and/or FR4.

In an embodiment, the shielding structure is composed of at least two sub-structures. For example, the at least two sub-structures are made of the same material or are made of different materials. Each sub-structure may provide a dedicated shielding function, in particular for shielding an assigned pin or pin portion. For instance, one sub-structure may shield the pin against electromagnetic radiation, whereas another sub-structure may shield the pin thermally and/or electrically

In an embodiment, the at least one at least partially conductive pin protrudes beyond at least one of the first main surface and the second main surface of the inorganic carrier. Additionally or alternatively, the at least one at least partially conductive pin may be retracted with respect to at least one of the first main surface and the second main surface of the inorganic carrier. This may allow to adjust an intentional asymmetry of the pin with respect to the inorganic carrier for partially or entirely compensating an asymmetry of a metal distribution on both opposing main surfaces of the inorganic carrier. This may lead, in turn, to less warpage and/or delamination tendencies. This retracted structure may provide a recess in one of the main surfaces of the inorganic carrier and it can have an opening to form or accommodate an electrical interconnection structure to connect with other layers or elements.

In an embodiment, the stack comprises at least one redistribution structure on the first main surface and/or the second main surface of the inorganic carrier. For example, such a redistribution structure may be embodied as multilayer stack with an interior wiring structure. A redistribution structure may function as an electric interface between larger electrically conductive structures, as characteristic for a PCB on one side of the inorganic carrier, and smaller electrically conductive structures of a surface mounted component, as characteristic for semiconductor technology on the opposing other side of the inorganic carrier. The other surface of the inorganic carrier without redistribution structure (for instance redistribution layer, RDL) may have layers (plus the thickness of the protruded copper pin) with the same thickness of the RDL on the other side. Therefore, even the layer count may be different, but the asymmetric structure may still control the warpage. The redistribution structure formed on one main surface of inorganic carrier can have a very fine line structure and high density. Moreover, the electrical signal transmission quality is also better than with conventional organic carrier products. This may be beneficial for high performance computing applications.

In an embodiment, the inorganic carrier with conductive pin filled in the through hole enables a two sided RDL with high density and fine line structuring, such as 5 µm/5 µm trace width or line space ratio, 3 µm/3 µm trace width or line space ratio or even 1 µm/1 µm trace width or line space ratio on two sides of the inorganic carrier. This may be achieved since the flatness and the stiffness of the inorganic carrier can guarantee a minimum warpage and shrinkage during manufacturing, as well as uniformity for each layer and pattern. In addition, the conductive pin inserted into the through hole can ensure the complete filling even of a high aspect ratio-type through hole. Furthermore, good adhesion between the conductive material and a surface of the through hole may be achieved, which may ensure a good electrical conductivity and signal transmission in the component carrier. Finally, a high density RDL on both sides of the inorganic carrier can enable manufacture of a big form factor product application, such as for massive scale computing or advanced AI computing or quantum computing.

In an embodiment, the at least one redistribution structure is electrically coupled with at least one extremity of the at least one at least partially conductive pin. For example, the redistribution structure may be arranged on one side of the inorganic carrier and may be in electric contact with conductive pins in the inorganic carrier. On the other side of the inorganic carrier, the conductive pins may be exposed for enabling an electric coupling with larger dimensions and/or smaller integration density than on the side of the inorganic carrier with redistribution structure. In the context of the present application, the term "integration density" may denote the number of electrically conductive elements (in particular trace elements, such as wiring structures, connection elements, such as pads, and/or vertical through-connections, such as metal through-holes) per unit area or volume of the respective layer stack. Thus, the amount of electrically conductive elements in a higher density laminate may be higher than the amount of electrically conductive elements in a lower density laminate. Thus, the integration density may mean the number of electrically conductive elements per unit area or volume. The integration density in the lower density layer stack may be less than the integration density in the higher density layer stack. Correspondingly, the line space ratio (line pitch) and/or line pitch in a lower density layer stack may be higher than the line space ratio and/or line pitch in a higher density layer stack. The term "line spacing" may denote the distance between corresponding edges of two adjacent electrically conductive elements.

In an embodiment, the encapsulating material forms at least part of a surface finish layer. Such a surface finish layer may for instance be a patterned solder resist. This may reduce the number of process steps of forming the component carrier and thus may simplify the manufacturing process.

In an embodiment, the surface finish layer comprises at least one opening exposing one extremity of the at least one at least partially conductive pin. Thus, said patterned surface finish layer may allow to establish an electric contact with the conductive pins embedded in the inorganic carrier.

In an embodiment, the component carrier has one side with lower density and has only one layer of surface finish layer with very low Young modulus. The conductive pin may be exposed in the surface finish layer, so that the structure can help reduce the layer count at one side and may reduce the manufacturing effort with low cost and better yield. Moreover, the whole signal path may be shorted, the loss may be reduced and signal transmission speed may be improved as well as signal integrity may be better.

In an embodiment, the component carrier comprises at least one interconnection structure in the at least one opening. For instance, such an interconnection structure may comprise a metallic via (for instance a copper via), a solder structure (such as a solder bump), or copper pillar ,a sinter structure (for instance sinter paste), and/or electrically conductive glue, etc.

In an embodiment, the at least one electrically insulating layer structure encapsulating the at least one at least partially conductive pin in the through hole is aligned (or flushed) with at least one external surface of a layer structure of the stack and/or with at least one of the first main surface and the second main surface of the inorganic carrier. This may contribute to a symmetric configuration of the component carrier. This may provide a good flatness and uniformity for the dielectric layer attached on the surface. Consequently, adhesion between the dielectric layer and the inorganic carrier may be better. Additionally, this may decrease the encapsulation volume of the encapsulating material.

In an embodiment, a further electrically insulating layer structure of the stack is provided on an opposing side of the inorganic carrier than the electrically insulating layer structure providing the encapsulating material, wherein said further electrically insulating layer structure is in contact with said encapsulating material. For example, electrically insulating layer structures may be laminated on both opposing main surfaces of the inorganic carrier. The electrically insulating layer structure laminated first may lead to a flow of resin into the pin-filled through hole for providing the encapsulating material. The further electrically insulating layer structure on the opposing side of the inorganic carrier laminated later may then connect to said encapsulant material upon lamination. The further electrically insulating layer structure may counter-act against the electrically insulating layer structure in terms of forces acting on the opposed main surfaces of the inorganic carrier. Such a symmetrical stack layering may reduce, in particular eliminate, warpage of the component carrier towards one side of the component carrier.

In an embodiment, the further electrically insulating layer structure has the same material properties as the encapsulating material. For instance, both the electrically insulating layer structure providing the encapsulant material and the other electrically insulating layer structure may comprise a sheet comprising resin, for instance epoxy resin, and optionally reinforcing particles, for instance glass spheres or glass fibers. With such a structure, an excellent layer to layer adhesion may be achieved, since there is no CTE mismatch with the same material property.

In an embodiment, the further electrically insulating layer structure has different material properties than the encapsulating material. Using different resins and/or reinforcing particles and/or different material compositions of the electrically insulating layer structures may offer a further design parameter for compensating asymmetric component carrier properties for suppressing warpage. With such a concept, it may be made use of the Young modulus property of different materials to design a mixed-material dielectric layer structure. Finally, this may allow to balance the CTE to manage the warpage.

In an embodiment, the component carrier comprises at least one solder structure (such as a solder bump) on an extremity of the at least one at least partially conductive pin. In particular, said solder structure may be located on and/or in the at least one electrically insulating layer structure encapsulating the pin. It may also be possible to provide solder structures on both opposing sides of the component carrier. For instance, a first solder structure may be arranged on an exposed electrically conductive structure of a redistribution layer and a second solder structure may be arranged on an exposed extremity of the pin(s). In accordance with the functionality of the redistribution layer, the first solder structure may have smaller dimensions than the second solder structure and/or a larger number of first solder structures compared with a smaller number of second solder structures may be provided.

In an embodiment, the at least one at least partially conductive pin forms a vertical through connection extending vertically through the inorganic carrier. Thus, the pins may extend vertically through the inorganic carrier. This may lead to short signal paths and therefore to a high signal integrity and low losses.

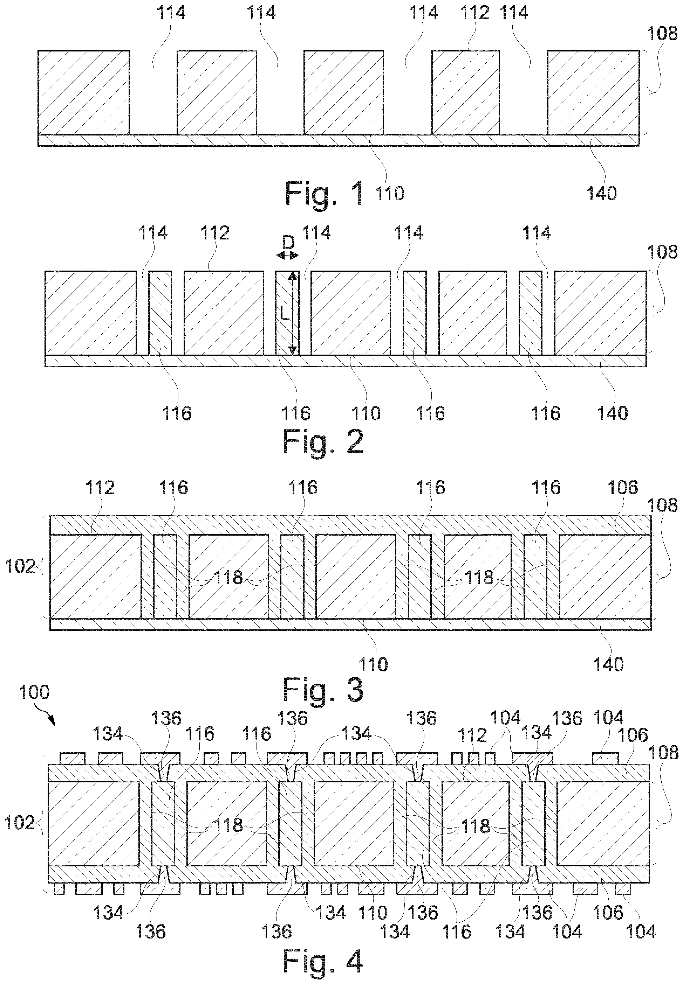

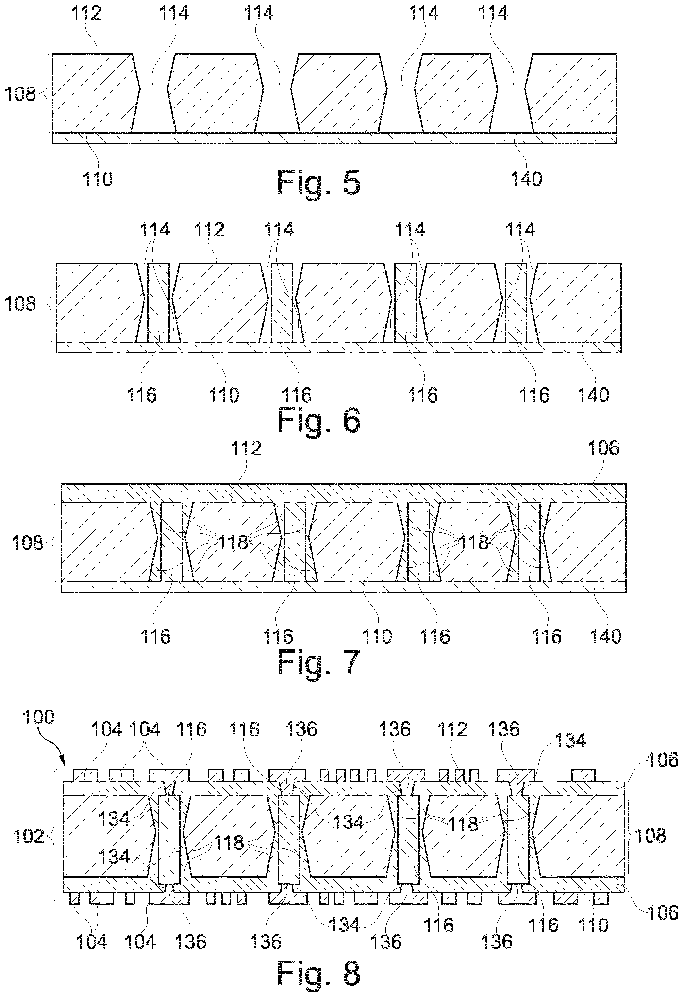

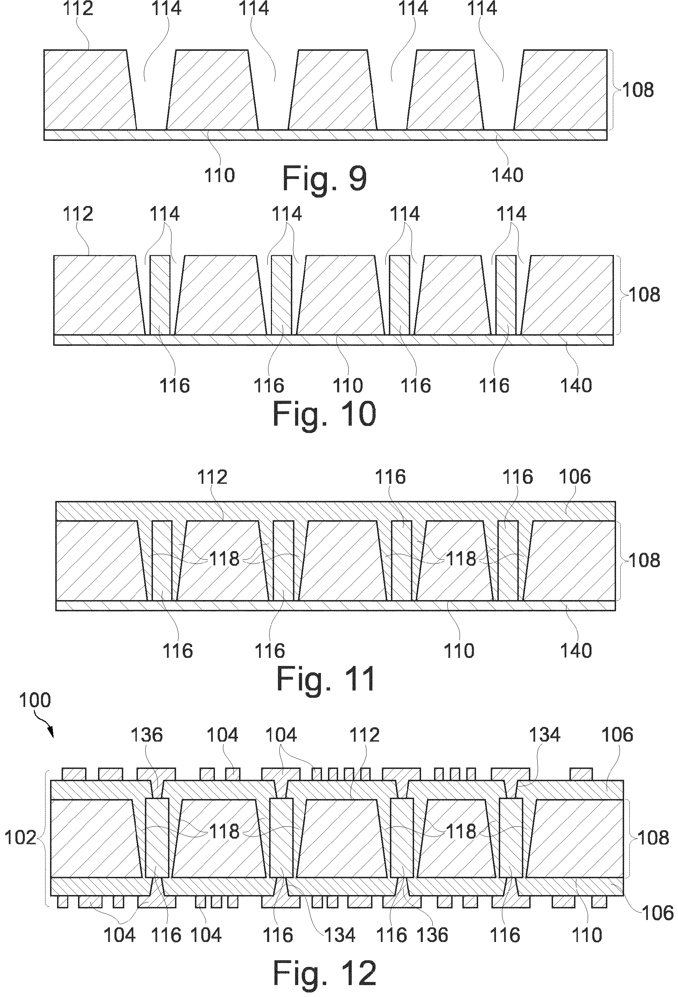

In an embodiment, the through hole has tapering sidewalls, vertical sidewalls, or an hourglass shape. An embodiment with tapering sidewalls is shown in Figure 12 and can be obtained by laser processing from one side of the inorganic carrier. An embodiment with vertical sidewalls is shown in Figure 4 and can be obtained by mechanical processing. An embodiment with hourglass shape is shown in Figure 8 and can be obtained by laser processing from both sides of the inorganic carrier. This may increase the design flexibility while at the same time ensuring a reliable through hole connection when the at least partially conducive pin is located in the through hole.

In an embodiment, the at least one at least partially conductive pin is an inlay. Hence, the respective pin may be pre-formed outside of the through hole and may then be inserted as a separate element into the through hole. This may simplify manufacture of the pin and may allow to freely design the pin.

In an embodiment, said first main surface and/or said second main surface is or are planar. In particular, the inorganic carrier may be a plate with flat and parallel main surfaces. This may enable a production of electrically conductive layer structures having a design with a lateral extension of the electrically conductive layer structure smaller than 5 µm, in particular smaller than 3 µm. The flatness of the inorganic carrier may be a crucial parameter for allowing a production of electrically conductive layer structures, for example traces, having small lateral extensions.

In an embodiment, the component carrier comprises at least one non-conductive structure in said through hole. Such a structure may be thermally and/or electrically non-conductive.

In an embodiment, the inorganic carrier body comprises or consists of glass, a ceramic, a semiconductor, or a metal. Thus, appropriate materials for an inorganic carrier body are glass (in particular silicon-based glass), a ceramic (such as aluminum nitride and/or aluminum oxide), and a material comprising a semiconductor (such as silicon oxide, silicon, silicon carbide, gallium nitride, etc.). It is also possible to make the inorganic carrier structure of a metallic material, such as copper. The inorganic carrier body may impart its physical properties, for example stiffness, Young's Modulus, CTE etc., to the component carrier and thus may enable the component carrier to be used in harsh conditions, for example at temperatures over 60 °C. Additionally or alternatively, the inorganic carrier structure may give a further functionality to the component carrier, for example a thermal path, which is guided through the inorganic carrier structure.

In an embodiment, the inorganic carrier comprises or consists of glass. In particular, the inorganic carrier may be a glass core or glass plate. Most preferred is an inorganic carrier comprising glass or consisting of glass. Such an inorganic carrier may comprise or consist of silicon dioxide. In particular, the inorganic carrier may have glass as main constituent. For example, the inorganic carrier may be block-, strip- or plate-shaped. The major material component (in particular the material component of the inorganic carrier providing the highest weight percentage) of the inorganic carrier is glass, in particular silicon-based glass. For instance, at least 90 weight percent of the inorganic carrier may be glass. For example, the inorganic carrier may consist only of glass. It is however also possible that the inorganic carrier comprises one or more additional other materials. Advantageously, the inorganic carrier may have very flat surfaces so that a planarization stage during processing may be dispensable and fine line processing thereon or above it may be fully supported. Furthermore, the inorganic carrier may have a high degree of thermal stability so that thermally-caused undesired phenomena such as thermal stress, shrinkage, warpage and delamination will not impact the component carrier significantly. This can make the whole component carrier stable with controllable change of the dimension of the component carrier (such as shrinkage would be less), so the alignment of all elements related to the component carrier may be improved (such as layer to layer alignment, via to pad alignment, pad to via alignment, bump to opening alignment, etc.). Besides that, the coplanarity of components assembled on the component carrier may be improved (such as bumps, capacitors, etc.). Furthermore, glass material may show a low Dk and low Df behavior with good dielectric property and may therefore support low loss, high-frequency (in particular improving radio frequency, RF) and high-speed applications as well as high performance computing application with good signal integrity and low loss.

In an embodiment, the inorganic carrier comprises at least one cavity in which at least one component is embedded. In the context of the present application, the term "cavity" may particularly denote a blind hole or a through hole in the stack of the component carrier. For example, a cavity may be shaped and dimensioned for accommodating an electronic component (such as a semiconductor chip), a heat dissipation block (for instance a copper block or a ceramic block), or another component carrier entirely or partially therein. Preferably, only one blind hole is formed in the stack. Preferably, filling the through hole(s) in the inorganic carrier with encapsulant material and filling gaps in the cavity accommodating the component with encapsulant material may be carried out by a single common lamination process using the same electrically insulating layer structure.

In an embodiment, a ratio between a vertical thickness and a horizontal diameter of the at least one at least partially conductive pin is at least 2, in particular at least 3, or even at least 5. Hence, the manufacturing architecture according to exemplary embodiments of the invention may be properly compatible with high aspect ratios, for example up to 8 or more. This may suppress or even eliminate the problem which standard component carrier manufacturing is facing within a through hole filling or plating process, when the through hole has an aspect ratio larger than 2, in particular 3 or more. Since the at least partially conductive pin may be pre-manufactured, a void free at least partially conductive pin can be ensured and can be further inserted into the through hole.

In an embodiment, the method comprises closing the through hole by a temporary carrier, inserting the at least one at least partially conductive pin in said through hole and on said temporary carrier, thereafter carrying out said directly encapsulating, and removing the temporary carrier after said directly encapsulating. For example, such a temporary carrier may be a sticky tape or plate. Said temporary carrier may close the through hole(s) in the inorganic carrier and may allow to attach the pin(s) on an adhesive surface of the temporary carrier to provide temporarily stability before inserting encapsulant material in the gaps of the through hole(s).

In an embodiment, the method comprises carrying out said directly encapsulating by laminating the at least one electrically insulating layer structure onto the inorganic carrier. Lamination may involve the provision of elevated temperature and/or mechanical pressure. This is a simple way of permanently fixing the pins in the through holes.

In an embodiment, the at least partially conductive pin has a shape like a nail. The slim part is inserted into the through hole, while the broad part of the pin (in particular the head of the nail) is protruding out of the inorganic carrier. The head of the nail can be a copper pad which can be used for an easy contacting of the nail like a landing pad for via connection. The electrically insulating layer inside the through hole can be the top one, or the further electrically insulating layer structure can be the bottom one. More generally, the pin may have a stem and a laterally enlarged head on the stem. A step may be formed between stem and head. For instance, the shape of the pin may be nail-like or mushroom-like. The stem may also have a head on both opposing ends. The pin may then be bone-shaped.

In an embodiment, at least one extremity of the at least partially conductive pin comprises a solderable material, for example tin. Preferably, the solderable material is exposed, protruding from one main surface. This may bring the advantage of an easy connection to further parts or components. A further process step may comprise for example attaching of solder balls to the at least partially conductive pin.

In an embodiment, a component, like a resistance or capacitor, may be embedded into a further through hole. Preferably, the component has connection pads on its extremities. As the partially conductive pin, the component may have an elongated shape, which fits into the through hole. This may give further functionality to the component carrier and may simplify the manufacturing process having an embedded component.

In an embodiment, the component carrier comprises an electronic component mounted on or above the inorganic carrier and being electrically coupled with the at least one pin. One or more electronic components may be surface mounted. In the context of the present application, the term "electronic component" may particularly denote a member fulfilling an electronic task. Such an electronic component may be an active component such as a semiconductor chip comprising a semiconductor material, in particular as a primary or basic material. The electronic component may also be a passive component, for instance a capacitor or an inductor. Preferably, the electronic component comprises a semiconductor chip. The semiconductor chip may be made for instance based on a type IV semiconductor such as silicon or germanium, or may be a type III-V semiconductor material such as gallium arsenide. In particular, the semiconductor component may be a semiconductor chip such as a bare die or a molded die. A bare die may be a non-encapsulated (in particular non-molded) piece of semiconductor material (such as silicon) having at least one monolithically integrated circuit element (such as a diode or a transistor). Moreover, semiconductor materials suitable for photonic packages are also possible. For example, an electronic component to be surface mounted on the package may be an HBM (high-bandwidth memory) or a silicon interposer.

In an embodiment, the component carrier comprises a stack of at least one electrically insulating layer structure and at least one electrically conductive layer structure. For example, the component carrier may be a laminate of the mentioned electrically insulating layer structure(s) and electrically conductive layer structure(s), in particular formed by applying mechanical pressure and/or thermal energy. The mentioned stack may provide a plate-shaped component carrier capable of providing a large mounting surface for further components and being nevertheless very thin and compact.

In an embodiment, the component carrier is shaped as a plate. This contributes to the compact design, wherein the component carrier nevertheless provides a large basis for mounting components thereon. In particular a naked die as example for an electronic component can be surface mounted on a thin plate such as a printed circuit board.

In an embodiment, the component carrier is configured as one of the group consisting of a printed circuit board, a substrate (in particular an IC substrate), and an interposer.

In the context of the present application, the term "printed circuit board" (PCB) may particularly denote a plate-shaped component carrier which is formed by laminating several electrically conductive layer structures with several electrically insulating layer structures, for instance by applying pressure and/or by the supply of thermal energy. As preferred materials for PCB technology, the electrically conductive layer structures are made of copper, whereas the electrically insulating layer structures may comprise resin and/or glass fibers, so-called prepreg or FR4 material. The various electrically conductive layer structures may be connected to one another in a desired way by forming holes through the laminate, for instance by laser drilling or mechanical drilling, and by partially or fully filling them with electrically conductive material (in particular copper), thereby forming vias or any other through-hole connections. The filled hole either connects the whole stack, (through-hole connections extending through several layers or the entire stack), or the filled hole connects at least two electrically conductive layers, called via. Similarly, optical interconnections can be formed through individual layers of the stack in order to receive an electro-optical circuit board (EOCB). A printed circuit board is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers).

In the context of the present application, the term "substrate" may particularly denote a small component carrier, in particular an IC substrate. An IC substrate may be, in relation to a PCB, a comparably small component carrier onto which one or more components may be mounted and that may act as a connection medium between one or more chip(s) and a further PCB. For instance, an IC substrate may have substantially the same size as a component (in particular an electronic component) to be mounted thereon (for instance in case of a Chip Scale Package (CSP)). More specifically, an IC substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections may in particular be arranged within the IC substrate and may be used to provide electrical, thermal and/or mechanical connections of housed components or unhoused components (such as bare dies), particularly of IC chips, with a printed circuit board or intermediate printed circuit board. A "substrate" in the context of the present application in particular facilitates electrical connections and/or dissipating heat and/or offering mechanical strength. Thus, the term "substrate" is in particular used as a synonym of "IC substrate" in the context of the present application. It has to be noted that the term "substrate" may in particular not been mixed up with the term "substrate" as it is usually used in the wafer context in which "substrate" usually means the substrate material used in wafer manufacturing as a base material upon which devices or circuits are built and which forms the foundational layer that supports the electronic or photonic structures integrated into a wafer. This is not what is meant with "substrate" in the context of the present application.

The substrate or interposer may comprise or consist of at least a layer of glass, silicon (Si) and/or a photoimageable or dry-etchable organic material like epoxy-based build-up material (such as epoxy-based build-up film) or polymer compounds (which may or may not include photo- and/or thermosensitive molecules) like polyimide or polybenzoxazole.

In an embodiment, the at least one electrically insulating layer structure comprises at least one of the group consisting of a resin or a polymer, such as epoxy resin, cyanate ester resin, benzocyclobutene resin, Melamine derivates, Polybenzoxabenzole (PBO), bismaleimide-triazine resin, polyphenylene derivate (e.g. based on polyphenylenether, PPE), polyimide (PI), polyamide (PA), liquid crystal polymer (LCP), polytetrafluoroethylene (PTFE), Bisbenzocyclobutene (BCB) and/or a combination thereof. Reinforcing structures such as webs, fibers, spheres or other kinds of filler particles, for example made of glass (multilayer glass) in order to form a composite, could be used as well. A semi-cured resin in combination with a reinforcing agent, e.g. fibers impregnated with the above-mentioned resins is called prepreg. These prepregs are often named after their properties e.g. FR4 or FRS, which describe their flame retardant properties. Although prepreg particularly FR4 are usually preferred for rigid PCBs, other materials, in particular epoxy-based build-up materials (such as build-up films) or photoimageable dielectric materials, may be used as well. For high frequency applications, high-frequency materials such as polytetrafluoroethylene, liquid crystal polymer and/or cyanate ester resins, may be preferred. Besides these polymers, low temperature cofired ceramics (LTCC) or other low, very low or ultra-low DK materials may be applied in the component carrier as electrically insulating structures.

In an embodiment, the at least one electrically conductive layer structure comprises at least one of the group consisting of copper, aluminum, nickel, silver, gold, palladium, tungsten, titanium and magnesium. Although copper is usually preferred, other materials or coated versions thereof are possible as well, in particular coated with supra-conductive material or conductive polymers, such as graphene or poly(3,4-ethylenedioxythiophene) (PEDOT), respectively.

The at least one component can be selected from a group consisting of an electrically non-conductive inlay, an electrically conductive inlay (such as a metal inlay, preferably comprising copper or aluminum), a heat transfer unit (for example a heat pipe), a light guiding element (for example an optical waveguide or a light conductor connection), an electronic component, or combinations thereof. An inlay can be for instance a metal block, with or without an insulating material coating (IMS-inlay), which could be surface mounted for the purpose of facilitating heat dissipation. Suitable materials are defined according to their thermal conductivity, which should be at least 2 W/mK. Such materials are often based, but not limited to metals, metal-oxides and/or ceramics as for instance copper, aluminium oxide (Al₂O₃) or aluminum nitride (AIN). In order to increase the heat exchange capacity, other geometries with increased surface area are frequently used as well. Furthermore, a component can be an active electronic component (having at least one p-n-junction implemented), a passive electronic component such as a resistor, an inductance, or capacitor, an electronic chip, a storage device (for instance a DRAM or another data memory), a filter, an integrated circuit (such as field-programmable gate array (FPGA), programmable array logic (PAL), generic array logic (GAL) and complex programmable logic devices (CPLDs)), a signal processing component, a power management component (such as a field-effect transistor (FET), metal-oxide-semiconductor field-effect transistor (MOSFET), complementary metal-oxide-semiconductor (CMOS), junction field-effect transistor (JFET), or insulated-gate field-effect transistor (IGFET), all based on semiconductor materials such as silicon carbide (SiC), gallium arsenide (GaAs), gallium nitride (GaN), gallium oxide (Ga₂O₃), indium gallium arsenide (InGaAs) and/or any other suitable inorganic compound), an optoelectronic interface element, a light emitting diode, a photocoupler, a voltage converter (for example a DC/DC converter or an AC/DC converter), a cryptographic component, a transmitter and/or receiver, an electromechanical transducer, a sensor, an actuator, a microelectromechanical system (MEMS), a microprocessor, a capacitor, a resistor, an inductance, a battery, a switch, a camera, an antenna, a logic chip, and an energy harvesting unit. However, other components may be surface mounted on the component carrier. For example, a magnetic element can be used as a component. Such a magnetic element may be a permanent magnetic element (such as a ferromagnetic element, an antiferromagnetic element, a multiferroic element or a ferrimagnetic element, for instance a ferrite core) or may be a paramagnetic element. However, the component may also be an IC substrate, an interposer or a further component carrier, for example in a board-in-board configuration. The component may be surface mounted on the component carrier. Moreover, also other components, in particular those which generate and emit electromagnetic radiation and/or are sensitive with regard to electromagnetic radiation propagating from an environment, may be used as component.

In an embodiment, the component carrier is a laminate-type component carrier. In such an embodiment, the component carrier is a compound of multiple layer structures which are stacked and connected together by applying a pressing force and/or heat.

After processing interior layer structures of the component carrier, it is possible to cover (in particular by lamination) one or both opposing main surfaces of the processed layer structures symmetrically or asymmetrically with one or more further electrically insulating layer structures and/or electrically conductive layer structures. In other words, a build-up may be continued until a desired number of layers is obtained.

After having completed formation of a stack of electrically insulating layer structures and electrically conductive layer structures, it is possible to proceed with a surface treatment of the obtained layers structures or component carrier.

In particular, an electrically insulating solder resist may be applied to one or both opposing main surfaces of the layer stack or component carrier in terms of surface treatment. For instance, it is possible to form such a solder resist on an entire main surface and to subsequently pattern the layer of solder resist so as to expose one or more electrically conductive surface portions which shall be used for electrically coupling the component carrier to an electronic periphery. The surface portions of the component carrier remaining covered with solder resist may be efficiently protected against oxidation or corrosion, in particular surface portions containing copper.

It is also possible to apply a surface finish selectively to exposed electrically conductive surface portions of the component carrier in terms of surface treatment. Such a surface finish may be an electrically conductive cover material on exposed electrically conductive layer structures (such as pads, conductive tracks, etc., in particular comprising or consisting of copper) on a surface of a component carrier. If such exposed electrically conductive layer structures are left unprotected, then the exposed electrically conductive component carrier material (in particular copper) might oxidize, making the component carrier less reliable. A surface finish may then be formed for instance as an interface between a surface mounted component and the component carrier. The surface finish has the function to protect the exposed electrically conductive layer structures (in particular copper circuitry) and enable a joining process with one or more components, for instance by soldering. Examples for appropriate materials for a surface finish are Organic Solderability Preservative (OSP), Electroless Nickel Immersion Gold (ENIG), Electroless Nickel Immersion Palladium Immersion Gold (ENIPIG), gold (in particular hard gold), chemical tin, nickel-gold, nickel-palladium, etc.

The aspects defined above and further aspects of the invention are apparent from the examples of embodiment to be described hereinafter and are explained with reference to these examples of embodiment.
Figure 1 to Figure 4 illustrate cross-sectional views of structures obtained during carrying out a method of manufacturing a component carrier, shown in Figure 4, according to an exemplary embodiment of the invention.
Figure 5 to Figure 8 illustrate cross-sectional views of structures obtained during carrying out a method of manufacturing a component carrier, shown in Figure 8, according to another exemplary embodiment of the invention.
Figure 9 to Figure 12 illustrate cross-sectional views of structures obtained during carrying out a method of manufacturing a component carrier, shown in Figure 12, according to another exemplary embodiment of the invention.
Figure 13 to Figure 16 illustrate cross-sectional views of structures obtained during carrying out a method of manufacturing a component carrier, shown in Figure 16, according to another exemplary embodiment of the invention.
Figure 17 to Figure 20 illustrate cross-sectional views of structures obtained during carrying out a method of manufacturing a component carrier, shown in Figure 20, according to another exemplary embodiment of the invention.
Figure 21 to Figure 24 illustrate cross-sectional views of structures obtained during carrying out a method of manufacturing a component carrier, shown in Figure 24, according to another exemplary embodiment of the invention.
Figure 25 to Figure 30 illustrate cross-sectional views of structures obtained during carrying out a method of manufacturing a component carrier, shown in Figure 30, according to another exemplary embodiment of the invention.
Figure 31 illustrates a cross-sectional view of a component carrier according to an exemplary embodiment of the invention, in comparison with a conventional component carrier.
Figure 32 illustrates cross-sectional views of component carriers according to an exemplary embodiment of the invention, showing different kinds of misalignment.

The illustrations in the drawings are schematic. In different drawings, similar or identical elements are provided with the same reference signs.

Before, referring to the drawings, exemplary embodiments will be described in further detail, some basic considerations will be summarized based on which exemplary embodiments of the invention have been developed.

When using for example a glass core for a package substrate, it may be requested to form a copper via in such a glass core. For certain applications, a high aspect ratio may be desired, for instance a ratio between a length and diameter of such a copper via of 8:1. At the same time, it may be required to form a thin surface copper layer which may be challenging in view of the need to manufacture a sufficiently filled copper via.

With a conventional manufacturing architecture, it may be a challenge to meet these requirements.

According to an exemplary embodiment of the invention, a component carrier (for example an IC substrate composed of organic and inorganic material) is formed based on a layer stack (which may be interconnected preferably by lamination). The stack may comprise a heterogeneous material composition including an inorganic carrier (for example a glass carrier or a ceramic carrier) through which at least one through hole extends preferably vertically along the whole path from a top side to a bottom side of the inorganic carrier. One or more pre-formed at least partially conductive (preferably electrically conductive) pins may be inserted into the through hole(s). For instance, such pins may be copper pillars. During practical use of the component carrier, electric signals and/or electric energy may be guided along the pin(s) through the inorganic carrier. Additionally or alternatively, it may also be possible that a thermally conductive pin is used for dissipation of heat. Advantageously, each respective pin may be directly embedded in an encapsulation material in the through hole of the inorganic carrier. The source of this encapsulation material may be beneficially an electrically insulating layer structure of the stack, so that for instance resin from said layer structure may flow into the through hole during lamination of the stack for forming the encapsulating material. The described component carrier architecture may ensure efficient conductive connection vertically through the entire inorganic carrier via the pin(s). Further advantageously, each pin may be reliably positioned within a through hole thanks to the encapsulating material of one or more electrically insulating layer structures of the stack. By using inlay-type pins as conductive through hole filling, a void-free filling of the through holes with conductive material may be possible. Simultaneously, anyway present stack dielectric may be used also for pin encapsulation which may reduce the manufacturing effort. Furthermore, a component carrier according to an exemplary embodiment of the invention may allow a strongly improved warpage management.

For example, a component carrier may be provided which may be configured as glass core interposer substrate. However, also other inorganic material than glass may be possible according to exemplary embodiments. For instance, such a component carrier with interposer characteristics may be manufactured by placing one or more conductive pins in the through holes of the glass substrate (or other inorganic carrier), holding them in place (for instance with an adhesive tape) and encapsulating them in a subsequent process. Hence, exemplary embodiments may allow to manufacture a component carrier with a simple process of connecting an inorganic carrier (such as a glass core) with conductive (for instance copper) pins which may be attached into through holes of the inorganic carrier (such as through glass vias, TGV). Such a manufacturing architecture may also allow to achieve a better warpage management of asymmetrically structured interposers with balanced back side.

The inorganic carrier of the component carrier may be configured as a glass core. Such a glass core may be a structured glass plate, but may also be functionalized. It is also possible to use an embedded and/or hybrid glass core for this purpose. Advantageously, the component carrier may be embodied as glass core interposer which may be provided with one or more fine structured redistribution layers (RDL), or more generally redistribution structures. Advantageously, insertion of a pre-formed or inlay-type copper pin may replace a conventional electrolytic copper plating and patterning, which may be cumbersome and prone to failure. Thus, a simple and reliable component carrier may be manufactured.

For instance, component carriers according to exemplary embodiments, in particular when embodied as glass core interposer, may be used for applications such as servers, artificial intelligence devices, high-performance computing (HPC) devices and related electronic devices.

Compared with conventional approaches, exemplary embodiments may provide a better structuring performance thanks to copper pin insertion into through holes of a glass core. In particular, such a copper pin insertion may replace a conventional copper plating process of filling TGVs and a corresponding patterning process. With such an approach, conventional shortcomings of manufacturing such a glass component carrier (such as poor adhesion between plating copper structure and through hole, poor filling caused by a bad ratio of the whole through hole and a void) can be avoided.

According to exemplary embodiments, a component carrier comprises a stack comprising at least one electrically conductive layer structure and at least one electrically insulating layer structure, an inorganic carrier, in particular an inorganic core, provided in the stack, wherein said inorganic carrier, in particular the inorganic core, has a planar first main surface and an opposing planar second main surface, a through hole in the inorganic carrier, in particular an inorganic core, extending between the first main surface and the second main surface and delimited by sidewalls, wherein at least one conductive through connection structure and non-conductive structure are provided in said through hole, and wherein the at least one conductive through connection structure comprises an at least partially conductive pin, and said at least one conductive through connection structure being directly encapsulated in the through hole by an encapsulation material. Preferably, the encapsulation material may be composed of at least one electrically insulating layer structure of the stack. In an example, the encapsulation material may be in direct contact with at least one lateral wall of the at least partially conductive pin. In a further example, the encapsulation material may be in direct contact with at least one extremity, in particular top and/or bottom, of the at least partially conductive pin. In an example, the inorganic carrier may have an extension in thickness direction in the range from 50 µm to 1.2 mm, in particular in the range between 200 µm to 1000 µm.

For instance, the pin comprises two extremities, one extremity flushing with one main surface of the inorganic carrier, in particular inorganic core, main surface (for instance on the side of a temporary carrier such as a tape). For example, the core can comprise, on the main surfaces and eventually in the lateral walls of the through hole, an additional layer of insulating material, in particular configured with adhesion promoting features. Preferably, the pin comprises two extremities, one extremity being misaligned (in particular along the stack thickness direction) with respect to one main surface of the core main surface. For instance, one extremity is flushed with one main surface, the opposed extremity is misaligned with respect to the opposed main surface. For instance, such a misalignment may be due to tolerances or may be larger than tolerances. The misaligned extremity may be due to the fact that the pin is an inserted component, not built in the stacking process, and then misaligned from the core main surface due to its tolerances or due to a specific wanted extension from or recess in the core. In particular, the pin may be misaligned along the stack thickness direction. Additionally or alternatively, it is possible that the misaligned pin is tilted or inclined with respect to the stack thickness direction. It is also possible that the pin is misaligned with respect to the through hole (for instance, the pin may protrude beyond the inorganic carrier or may be retracted with respect to the inorganic carrier). For example, the pin may be decentered (in particular laterally) with respect to the through hole. It is also possible that there is more encapsulated material between the through hole lateral wall and the at least one conductive through connection structure on one side with respect to the opposed side.

In an embodiment, a plurality of through holes may be formed in the inorganic carrier. A plurality of pins may be provided, each one in a respective through hole. For example, the distance of two extremities of two pins may be different from the distance of the opposed two extremities of the same pins, in particular of 1 to 20% of the height of the pin.

What concerns the shape of the at least one pin, it may for example have a cross circular-quadrangular or other shape. In particular, the shape of the pin may be different from the shape of the through hole. Different shapes of the through holes may impact the alignment of the pins. Alternatively, the shape of the at least partially conductive pin may be similar, in particular the same, as the through hole.

What concerns shielding, the at least one conductive pin (which may be a through connection structure) may be surrounded with a shielding portion (for instance embodied as a shielding coating), in particular shielding the pin (in particular laterally and/or on a top side and/or on a bottom side of the pin). Such a shielding structure may be comprised in the through hole. In particular, it may be possible that the shielding portion or structure flushes with at least one, in particular two of the main surfaces of the layer structures of the stack, in particular with at least one, in particular two of the main surfaces of the inorganic carrier. For instance, the shielding portion or shielding structure may comprise insulating material (which may be electrically insulating material and/or thermally insulating material) and/or magnetic material only. For example, said portion or shielding structure may comprise two layers, in particular at least one insulating material and/or at least one magnetic material and/or at least one conductive material. In an embodiment, said two layers comprise the same material or are made of different materials. For example, said two layers flush with at least one, in particular two of the main surfaces of the layer structures of the stack, in particular with at least one, in particular two of the main surfaces of the inorganic carrier. For instance, the sidewall of conductive through connection structure and/or the sidewall of the at least partially conductive pin is at least partially covered by the shielding structures. In an embodiment, at least one of the sidewalls of the conductive through connection and/or the sidewall of the at least partially conductive pin is at least partially covered by the encapsulation structure. In an embodiment, a shielding layer can be made of a ferromagnetic material such as iron, copper and/or nickel (in particular, the ferromagnetic material can be electrically conductive or non-conductive, for instance ferrite). For example, a coating shielding layer can be made of other insulating material, such as a paste. For instance, the encapsulation layer can be made of resin with additives, a photoimageable dielectric, a solder resist, prepreg, and/or FR4.

For instance, the conductive pin is protruding beyond one of the main surfaces of the inorganic core or below. For example, the conductive pin can comprise a metal (such as a pure metal or an alloy) or other mixed conductive material with glue, conductive particle and resin. In an embodiment, a redistribution layer (RDL) may be formed on one of the main surfaces of the inorganic core. For instance, a vertical connection may extend through the encapsulating layer. For instance, a vertical connection may be connected to one extremity of the pin. In an embodiment, the pin may be configured for different electrical functions. Different pins may have different sizes, or may have the same size. In an example, the at least partially conductive pin may have an extension in thickness direction in the range from 5 µm to 1.2 mm, in particular in the range between 80 µm to 1000 µm. In another example, the at least partially conductive pin may have an extension in thickness direction larger than 100 µm, in particular larger than 150 µm. In a further example, the at least partially conductive pin may have an extension in lateral direction in the range from 5 µm to 250 mm, in particular in the range between 20 µm to 150 µm. For example, the encapsulation structure may be embodied as surface finishing layer (such as a metallic surface finish, a solder resist, etc.). For instance, the encapsulation structure is configured as surface finish layer. In an embodiment, the surface finish layer comprises at least one opening exposing one extremity of the at least one conductive through connection structure, in particular of the pin. For example, at least one interconnection structure may be placed in the opening. In an embodiment, a containing portion may be provided and may be configured as an exposed recess to contain at least a portion of the at least one interconnection structure. For example, the at least one electrically insulating layer structure encapsulating the at least one conductive pin in the through hole flushes with at least one of the external surface of one layer structure of the stack, in particular with at least one of the main surfaces of the inorganic core. For instance, a further electrically insulating layer structure or encapsulation is provided on the other side of the inorganic carrier, in particular inorganic core, being in contact with an encapsulated portion of the at least one electrically insulating layer structure. For example, the encapsulation structure may have the same material with the electrically insulating layer structure. In an embodiment, the encapsulation structure may have a different material than the electrically insulating layer structure. For example, a solder bump may be connected to a pin.

A commonly used integrated circuit (IC) substrate in PCB industry is organic-based laminate. However, organic laminates may not have a high degree of dimensional stability during manufacture, so that they may absorb moisture and may change dimension during a thermal process. Thus, it may be difficult to keep a stable dimension when purely relying on organic-based laminates. Basically, the warpage and/or shrinkage is always a big issue to impact the high volume manufacturing and quality of organic-based products as the products with warpage cannot be further processed and may be scraped in production due to incompatibility with the equipment. A product with shrinkage may result in pattern to pattern misalignment and/or layer to layer misalignment, so that the reliability or function may be impacted. In particular, such kind of issues have already become a big barrier for developing electrical products with fine line structuring and/or high density which may be used for high performance computing such as artificial intelligence (AI) devices. In order to overcome such shortcomings, glass material may be used as core material. Glass core material may have a significantly enhanced dimensional stability under thermal load, good flatness to process a fine redistribution structure and has a lower coefficient of thermal expansion than materials relating to a conventional IC substrate manufacturing process. A small pitch size of traces and a high alignment accuracy may be achieved when implementing a glass core in a packaging substrate. Exemplary embodiments of the invention provide such an inorganic carrier, such as a glass core interposer, in a stack, wherein the inorganic carrier can be processed in a simple way for manufacturing a powerful IC substrate. Warpage control may be improved by inserting conductive pins in through holes of a glass core, or another inorganic carrier. Encapsulating such pins in the through holes of the inorganic carrier by dielectric stack material may significantly simplify the manufacturing process.

More specifically, a component carrier according to exemplary embodiments of the invention allows a simplified process of glass core manufacture with copper pin attachment into TGVs. Advantageously, better warpage management may become possible even in this scenario of an asymmetric structure interposer with balanced back side. Furthermore, exemplary embodiments may enable glass core interposer manufacture with fine structure redistribution layer.

Figure 1 to Figure 4 illustrate cross-sectional views of structures obtained during carrying out a method of manufacturing a component carrier 100, shown in Figure 4, according to an exemplary embodiment of the invention. To put it shortly, the illustrated embodiment relates to a component carrier 100 with an inorganic carrier 108 embodied as glass core without copper plating by implementing pre-formed inlay-type electrically conductive pins 116.

Referring to **Figure 1****,** an inorganic carrier 108 is provided, which is here embodied as glass core. The inorganic carrier 108 will later form part of a stack 102 of the manufactured component carrier 100, see Figure 3 and Figure 4. As shown, said inorganic carrier 108 has a lower first main surface 110 and an opposing upper second main surface 112. In the shown embodiment, said first main surface 110 and said second main surface 112 are planar and parallel to each other. A plurality of vertical through holes 114 are formed in the inorganic carrier 108 extending vertically the hole path between the first main surface 110 and the second main surface 112. The through holes 114 are embodied as straight through glass vias (TGV) extending through the glass core-type inorganic carrier 108. For instance, such through holes 114 with vertical sidewalls may be formed by mechanically drilling.

Thereafter, the through holes 114 are closed at a bottom side by connecting a temporary carrier 140 onto the bottom-sided first main surface 110 of the inorganic carrier 108. For instance, the temporary carrier 140 may be an adhesive tape or plate.

Referring to **Figure 2**, a plurality of electrically conductive pins 116, which are here embodied as pre-formed or inlay-type copper pins, are inserted in said through holes 114 and are attached to an adhesive surface of the temporary carrier 140. Thus, each of the conductive pins 116 forms a vertical through connection extending vertically through the entire inorganic carrier 108. For instance, insertion of the pins 116 into the through holes 114 may be accomplished by a pick and place process. For example, the pins 116 may be put into a stencil, and the pins 116 may then be allowed to drop down into the respective through hole 114, or the pins 116 may be placed by shooting.

As shown in Figure 2, a ratio between a length or vertical thickness L and a width or horizontal diameter D of a respective conductive pin 116 may be at least 2, in particular at least 3, for instance at least 4. Thus, each conductive pin 116 may have a high aspect ratio. Contrary to conventional through holes filled by plating, the insertion of inlay-type pins 116 into through holes 114 of an inorganic carrier 108 is significantly less problematic what concerns an undesired formation of voids in an interior of such an electrically conductive structure.

Referring to **Figure 3****,** an electrically insulating layer structure 106 (for instance a sheet of prepreg, resin, photoimageable dielectric, a solder resist or glue or paste) may be attached to an upper main surface of the structure shown in Figure 2. Thereafter, a lamination process may be executed by elevating temperature and/or applying mechanical pressure, or a plug in process may be carried out. Consequently, still uncured resin of the electrically insulating layer structure 106 may become flowable and may flow into void or hollow regions between the inorganic carrier 108 and the pins 116 in the through holes 114. During a curing process, the resin may polymerize and/or cross-link and may resolidify permanently to thereby form a solid encapsulating material 118 in direct physical contact with the pins 116. Thus, the encapsulating material 118 is brought in direct physical contact with the sidewalls of the inorganic carrier 108 delimiting the through holes 114 and with the sidewalls of the pins 116 as well as with the top side of the pins 116.

As a result of the lamination of the electrically insulating layer structure 106 on the second main surface 112 of the inorganic carrier 108 and on the top side of the pins 116, a laminated layer stack 102 is formed based on said electrically conductive layer structure 104 and based on said inorganic carrier 108. Moreover, said lamination process directly encapsulates the electrically conductive pins 116 in the through holes 114 by the encapsulating material 118 of the top-sided electrically insulating layer structure 106 of the stack 102.

After said directly encapsulating process, the temporary carrier 140 may be removed. For instance, an adhesive tape forming the temporary carrier 140 may be detached. Such a process may be denoted as de-taping process.

Referring to **Figure 4****,** a component carrier 100 according to an exemplary embodiment of the invention is shown.

Based on the structure shown in Figure 3 and after removal of the temporary carrier 140, the component carrier 100 can be formed by laminating a further electrically insulating layer structure 106 onto the first main surface 110 of the inorganic carrier 106. The electrically insulating layer structures 106 on both main surfaces 110, 112 may then be patterned (for instance by executing a lithography and etching process). As a result of this patterning process, a top surface and a bottom surface of the pins 116 may be exposed. Electrically conductive material may be deposited for electrically connecting the pins 116 on the top side and on the bottom side thereof. For instance, this can be accomplished by copper plating. Thereafter, metal foils (such as copper foils) may be attached to the exposed main surfaces of the electrically insulating layer structures 106 and may be patterned. Alternatively, further metal layer may be deposited by electroless plating or sputtering and may then be patterned. As a result, electrically conductive layer structures 104 of the laminated layer stack 102 are formed. The thickness thereof may be freely adjusted independently of the pins 116.

The obtained component carrier 100, which may be embodied as an integrated circuit substrate, comprises the laminated layer stack 102 comprising electrically conductive layer structures 104 (for instance comprising copper) and electrically insulating layer structures 106 (for example comprising resin, such as epoxy resin, and optionally reinforcing particles, such as glass spheres or glass fibers) as well as the inorganic carrier 108 provided as part of the stack 102. Said inorganic carrier 108 is here embodied as a glass core and is covered by the electrically insulating layer structures 106 both on its first main surface 110 and on its opposing second main surface 112. The through holes 114 in the inorganic carrier 108 extend with vertical sidewalls between the first main surface 110 and the second main surface 112 and are each filled by a respective electrically conductive pin 116. Each of the electrically conductive pins 116 is directly encapsulated in the through hole 114 by encapsulating material 118 of the top-sided electrically insulating layer structure 106 of the stack 102.

Preferably, the electrically conductive pins 116 consist of a metal such as copper or another metallic material. Each material having a high electrical and/or thermal conductivity may be possible. Each electrically conductive pin 116 comprises a lower extremity aligned with the first main surface 110 and a top extremity aligned with the second main surface 112. Although not shown in Figure 1, a cross-sectional shape of each conductive pin 116 may be round, for example circular, or polygonal, for example rectangular. The pin 116 may also have a tapering shape, e.g. a frustoconical shape. A cross-sectional shape of a respective conductive pin 116 may be different from or may be the same as a cross-sectional shape of the through hole 114.

For example, the encapsulating material 118 forms part of a surface finish layer in form of the top-sided electrically insulating layer structure 106. As shown, this surface finish layer comprises openings 134 exposing the upper extremity of the conductive pins 116. Also the bottom-sided electrically insulating layer structure 106 may be a surface finish layer which comprises openings 134 exposing the lower extremity of the conductive pins 116. An interconnection structure 136, preferably made of copper, is formed in each opening 134. The bottom-sided further electrically insulating layer structure 106 of the stack 102 provided on an opposing side of the inorganic carrier 108 than the electrically insulating layer structure 106 providing the encapsulating material 118 is in contact with a bottom surface of said encapsulating material 118. For example, the further electrically insulating layer structure 106 may have the same material properties as the encapsulating material 118, for instance may comprise a cured resin. Alternatively, said further electrically insulating layer structure 106 may have different material properties than the encapsulating material 118. For instance, the encapsulating material 118 may comprise cured resin but no reinforcing particles, whereas the electrically insulating layer structure 106 and/or the further insulating layer structure 106 may comprise resin and reinforcing particles.

Figure 5 to Figure 8 illustrate cross-sectional views of structures obtained during carrying out a method of manufacturing a component carrier 100, shown in Figure 8, according to another exemplary embodiment of the invention. Basically, **Figure 5** corresponds to Figure 1, **Figure 6** corresponds to Figure 2, **Figure 7** corresponds to Figure 3, and **Figure 8** corresponds to Figure 4.

The embodiment of Figure 5 to Figure 8 differs from the embodiment according to Figure 1 to Figure 4 in particular in that, in the embodiment according to Figure 5 to Figure 8, the through holes 114 have an hourglass shape. Such an hourglass shape may be manufactured by forming the through holes 114 by laser processing from both opposing main surfaces 110, 112 of the inorganic carrier 108. Each single laser process may form a tapering partial hole, which will connect in an interior of the inorganic carrier 108 to form an hourglass shape together. Advantageously, the hourglass shape of the through holes 114 may form a bottleneck in an interior of each through hole 114 which will automatically center a pin 116 when being inserted therein.

Figure 9 to Figure 12 illustrate cross-sectional views of structures obtained during carrying out a method of manufacturing a component carrier 100, shown in Figure 12, according to another exemplary embodiment of the invention. Basically, **Figure 9** corresponds to Figure 1, **Figure 10** corresponds to Figure 2, **Figure 11** corresponds to Figure 3, and **Figure 12** corresponds to Figure 4.

The embodiment of Figure 9 to Figure 12 differs from the embodiment according to Figure 1 to Figure 4 in particular in that, in the embodiment according to Figure 9 to Figure 12, the through holes 114 have tapering sidewalls tapering towards the first main surface 110. Such a tapering shape may be manufactured by forming the through hole 114 by laser processing from the second main surface 112 of the inorganic carrier 108 only. Advantageously, the tapering shape of the through holes 114 towards the first main surface 110 may simplify insertion of the pin 116 into the through hole 114 while the tapering geometry will automatically center a pin 116 inserted therein.

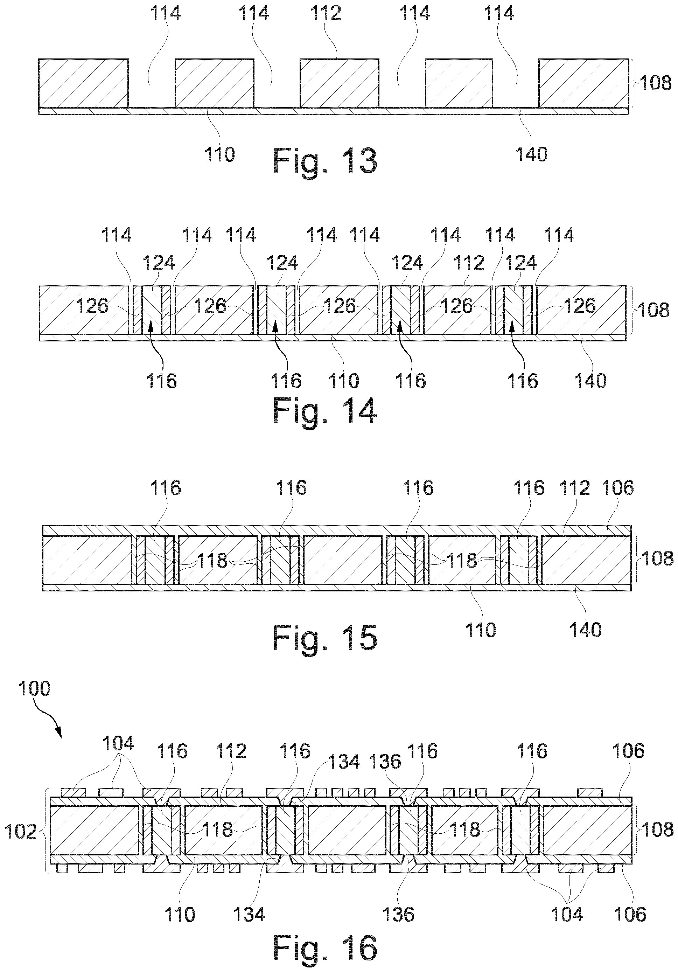

Figure 13 to Figure 16 illustrate cross-sectional views of structures obtained during carrying out a method of manufacturing a component carrier 100, shown in Figure 16, according to another exemplary embodiment of the invention. This embodiment relates to a functional glass core. Basically, **Figure 13** corresponds to Figure 1, **Figure 14** corresponds to Figure 2, **Figure 15** corresponds to Figure 3, and **Figure 16** corresponds to Figure 4.

The embodiment of Figure 13 to Figure 16 differs from the embodiment according to Figure 1 to Figure 4 in particular in that, in the embodiment according to Figure 13 to Figure 16, each partially conductive pin 116 comprises an electrically conductive core 124 having sidewalls being fully covered by a shell 126. Preferably, the shell 126 is configured as a shielding structure for providing a shielding functioning, for example for shielding the conductive core 124. For example, the shielding structure in form of the shielding shell 126 may shield the core 124 with regard to electromagnetic radiation or providing the inductive function. For this purpose, the shielding shell 126 may for instance be made of a ferromagnetic material (such as iron, cobalt or nickel). It is however also possible that the shielding shell 126 shields the core 124 with regard to an impact from the environment, such as shielding the core 124 against corrosion, oxidation or humidity. The shielding shell 126 may also shield the core 124 against electricity (for instance may be electrically insulating) and/or against thermal energy (for instance may be thermally insulating). In the shown embodiment, both opposing extremities of the shielding shell 126 are aligned with a respective one of the opposing main surfaces of the electrically insulating layer structures 106 of the stack 102 and with both of the first main surface 110 and the second main surface 112 of the inorganic carrier 108. The shielding shell 126 may be made of one homogeneous material or may be composed of two or more sub-structures (such as an upper portion and a lower portion, or two interleaved sleeves) which may be made of the same material or of different materials.

The embodiment of Figure 13 to Figure 16 may also be adapted with tapering or hourglass shaped through holes 114.

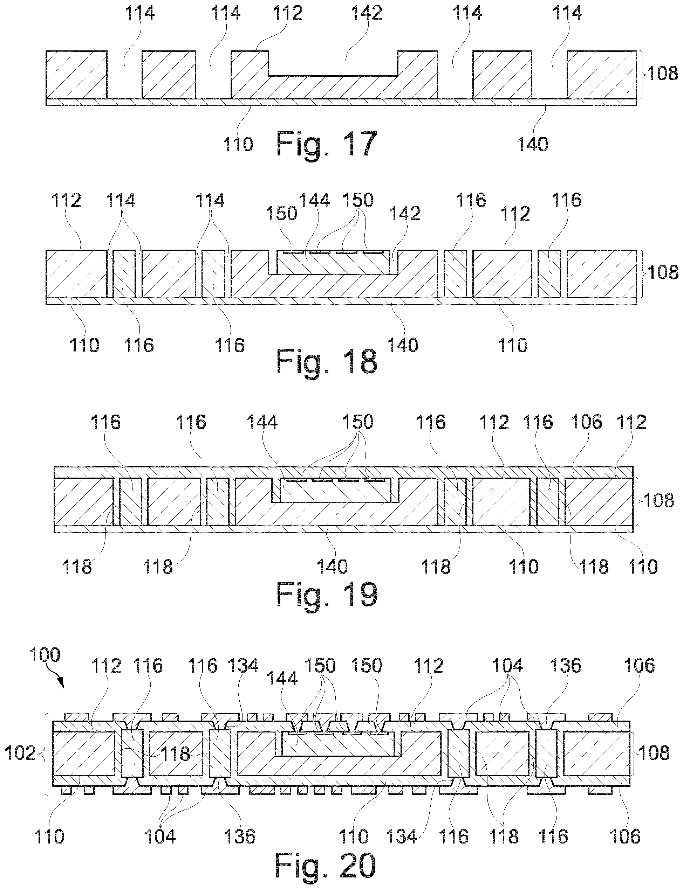

Figure 17 to Figure 20 illustrate cross-sectional views of structures obtained during carrying out a method of manufacturing a component carrier 100, shown in Figure 20, according to another exemplary embodiment of the invention. This embodiment relates to an embedding glass core. Basically, **Figure 17** corresponds to Figure 1, **Figure 18** corresponds to Figure 2, **Figure 19** corresponds to Figure 3, and **Figure 20** corresponds to Figure 4.

The embodiment of Figure 17 to Figure 20 differs from the embodiment according to Figure 1 to Figure 4 in particular in that, in the embodiment according to Figure 17 to Figure 20, the inorganic carrier 108 comprises a cavity 142 formed in the second main surface 112 in which a component 144 is embedded. More specifically, the cavity 142 is formed as a blind hole in the second main surface 112 of the inorganic carrier 108. The component 144 may be inserted in the cavity 142. For example, the component 144 may be an electronic component, such as a semiconductor die. In the shown embodiment, the electronic component 144 has electric terminals 150 on an upper main surface only. For fixing the component 144 in the cavity 142, the aforementioned electrically insulating layer structure 106 laminated onto the top main surface 112 of the inorganic carrier 108 and providing the encapsulating material 118 in the through holes 114 also fills at least part of remaining gaps of the cavity 142 after having inserted component 144 in the cavity 142. Thus, the same electrically insulating layer structure 106 may also provide encapsulating material for encapsulating component 144 in cavity 142, as shown in Figure 19. This allows a highly efficient embedding. As shown in Figure 20, forming the electrically conductive layer structures 104 for connecting the embedded pins 116 may simultaneously form electric connections for contacting the embedded terminals 150 through the upper electrically insulating layer structure 106.

The embodiment of Figure 17 to Figure 20 may also be adapted with tapering or hourglass shaped through holes 114.

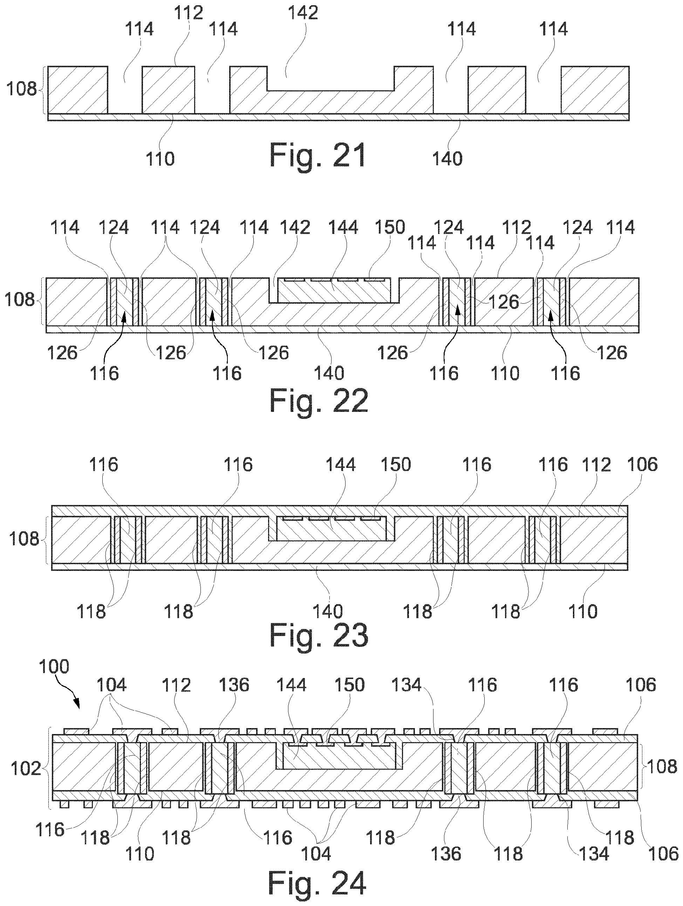

Figure 21 to Figure 24 illustrate cross-sectional views of structures obtained during carrying out a method of manufacturing a component carrier 100, shown in Figure 24, according to another exemplary embodiment of the invention. This embodiment may be denoted as hybrid glass core. Basically, **Figure 21** corresponds to Figure 17, **Figure 22** corresponds to Figure 18, **Figure 23** corresponds to Figure 19, and **Figure 24** corresponds to Figure 20.

The embodiment of Figure 21 to Figure 24 differs from the embodiment according to Figure 17 to Figure 20 in particular in that, in the embodiment according to Figure 21 to Figure 24, each partially conductive pin 116 comprises an electrically conductive core 124 having sidewalls being fully covered by a shell 126. Reference is made to the corresponding description of the shell 126 (for instance functioning as a shielding structure) referring to Figure 13 to Figure 16.

The embodiment of Figure 21 to Figure 24 may also be adapted with tapering or hourglass shaped through holes 114.

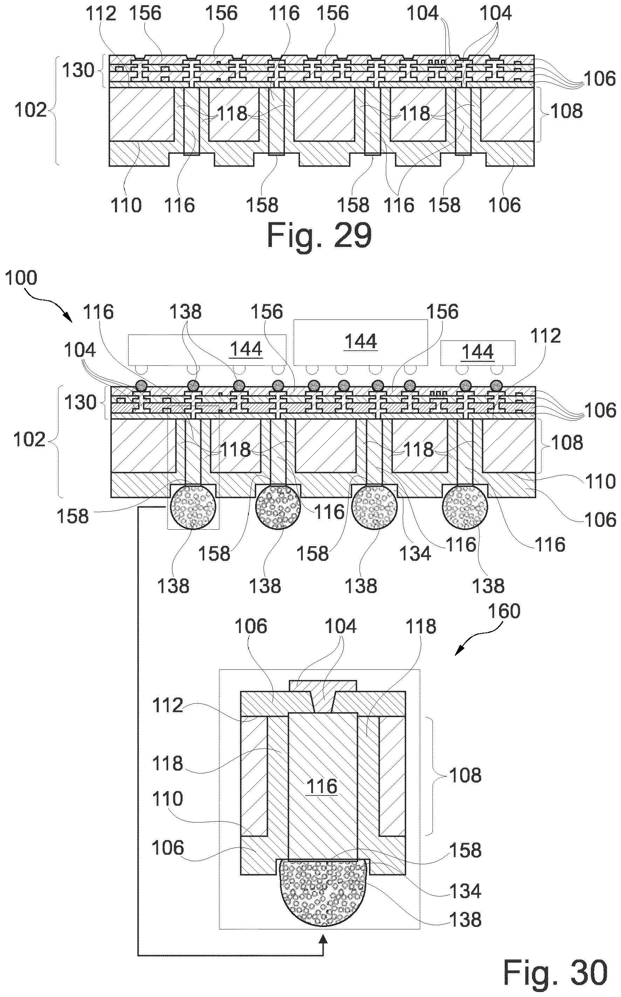

Figure 25 to Figure 30 illustrate cross-sectional views of structures obtained during carrying out a method of manufacturing a component carrier 100, shown in Figure 30, according to another exemplary embodiment of the invention.

Referring to **Figure 25****,** a structure as shown in Figure 1 is provided.

Referring to **Figure 26****,** conductive pins 116 are inserted into through holes 114 formed in inorganic carrier 108 and are attached at their bottom side to an adhesive surface of the temporary carrier 140. This process may be as described above referring to Figure 2 with the exception that the pins 116 protrude beyond the second main surface 112 of the inorganic carrier 108 according to Figure 26. Alternatively, the top end of the pins 116 may also be retracted with respect to the second main surface 112 of the inorganic carrier 108. In yet another alternative, the top end of the pins 116 may also be aligned with or may flush with the second main surface 112 of the inorganic carrier 108. In Figure 26, the conductive pin 116 comprises a bottom-sided first extremity being aligned with the first main surface 110 of the inorganic carrier 108 and comprises a top-sided second extremity being misaligned with the second main surface 112 of the inorganic carrier 108 by protruding beyond it.

Referring to **Figure 27****,** an electrically insulating layer structure 106 is laminated onto the top or second main surface 112 of the inorganic carrier 108 and onto the protruding portion of the electrically conductive pins 116 so that also resin material flows into the through holes 114 and forms the encapsulating material 118 directly encapsulating the pins 116 in the through holes 114 of the inorganic carrier 108. Thereafter, a further temporary carrier structure 152, such as a plate, may be attached to the exposed main surface of the electrically insulating layer structure 106. Bottom-sided temporary carrier 140 may be removed.

Referring to **Figure 28****,** the structure shown in Figure 27 may be turned upside down, i.e. may be rotated by 180°, before or after removal of temporary carrier 140. Furthermore, a redistribution structure 130 may be formed on the exposed second main surface 112 of the inorganic carrier 108. The redistribution structure 130 may be a redistribution layer comprising a plurality of electrically insulating layer structures 106 (such as laminated or deposited dielectric layers) and a plurality of electrically conductive layer structures 104 (such as patterned metal foils and/or metal vias). At the exposed surface of the redistribution structure 130, a surface finish 156 may be formed, such as a patterned layer of solder resist. As shown, electrically conductive layer structures 104 of the redistribution structure 130 are electrically coupled with the upper ends of the electrically conductive pins 116.

Referring to **Figure 29****,** the further temporary carrier structure 152 may be removed, for instance detached. Thereby, the electrically insulating layer structure 106 is exposed at a main surface of the obtained structure opposing the redistribution structure 130. Said electrically insulating layer structure 106 may then be patterned for exposing corresponding ends of the conductive pins 116. This may be denoted as back side opening. Thereafter, an electrically conductive surface finish 158 (such as ENIPIG) may be formed on the exposed surface portion of the pins 116.

Referring to **Figure 30****,** solder structures 138 (or other electrically conductive connection structures, such as a sinter structure) may be formed on the exposed extremities of the conductive pins 116 and on the portions of the electrically conductive layer structures 104 of the redistribution structure 130 exposed with respect to the solder resist-type surface finish 156. As shown, larger solder structures 138 may be applied to the bottom main surface of the obtained component carrier 100 as compared to smaller solder structures 138 at a top main surface of the component carrier 100. The integration density, i.e. the number of electrically conductive structures per volume, may be larger in the top portion of the component carrier 100 compared with the bottom portion of the component carrier 100.

One or more electronic components 144, such as semiconductor chips, may be surface mounted on the top main surface of the component carrier 100 according to Figure 30 and may be solder-connected with the stack 102 using the top-sided solder structures 138. At a bottom side of the IC substrate-type component carrier 100, the component carrier 100 may be connected on a mounting base such as a printed circuit board (PCB, not shown), for instance by establishing a solder connection using the bottom-sided solder structures 138.

A detail 160 of the obtained structure around a conductive pin 116 is shown in Figure 30 as well. The solder material may or may not be a nicely shaped ball in the final product. A skilled person will understand that the solder material may be in direct contact with the sidewalls and/or the main surface of the pin 116. Preferably, the solder material may fill up the gap in the electrically insulating layer structure 106.

**Figure 31** illustrates a cross-sectional view of a component carrier 100 according to an exemplary embodiment of the invention, in comparison with a conventional component carrier 162.

The conventional component carrier 162 shown on the top side of Figure 31 suffers from excessive warpage, as indicated by reference sign 164. This may be due to the inhomogeneous distribution of metal in different portions of the conventional component carrier 162.

In contrast to this, the more homogeneous metal distribution in the component carrier 100 according to Figure 31 may lead to significantly less warpage, as indicated by reference sign 166. For instance, by adjusting the degree of protrusion (or retraction) of the conductive pins 116 with respect to the inorganic carrier 108 (compare Figure 26), the metal distribution may be rendered more homogeneous over the different portions of the component carrier 100, despite of the different zones of higher integration density in redistribution structure 130 compared with lower integration density in inorganic carrier 108, thereby allowing for an efficient warpage management. Integration density may denote a number of electrically conductive structures per volume.

Advantageously, the glass core manufacturing process for obtaining component carrier 100 is simple. Compared with the conventional approach according to the upper illustration of Figure 31 (i.e. TGV, seed metallization, copper plating), an exemplary embodiment of the invention enables a better warpage management of an asymmetrically structured interposer with back side balancing by correspondingly adapting a pin design as the thickness of the back side is balanced with the front side by the height of the pin 116.

**Figure 32** illustrates cross-sectional views of component carriers 100 according to exemplary embodiments of the invention, showing different kinds of intentional pin misalignment for warpage management.

Referring to embodiment 180, the conductive pin 116 comprises two extremities being both misaligned with respect to the main surfaces 110, 112 of the inorganic carrier 108. The bottom-sided extremity of pin 116 is misaligned in a vertical direction with respect to the first main surface 110 and the top-sided extremity of pin 116 is misaligned in a vertical direction with respect to the second main surface 112 of the inorganic carrier 108. Thus, the illustrated conductive pin 116 is misaligned with respect to a thickness direction 120 of the stack 102. The illustrated conductive pin 116 protrudes beyond the second main surface 112 and is retracted with respect to the first main surface 110 of the inorganic carrier 108.

Referring to embodiment 182, the conductive pin 116 is misaligned laterally with respect to the through hole 114. More specifically, said conductive pin 116 is misaligned by being laterally displaced with respect to a central axis 122 of the through hole 114.

Referring to embodiment 184, the conductive pin 116 is misaligned by being tilted with respect to the thickness direction 120 of the stack 102.

It may also be possible that a conductive pin 116 is misaligned by providing a larger amount of encapsulating material 118 between one delimiting sidewall of the through hole 114 and the conductive pin 116 in comparison with a smaller amount of encapsulating material 118 between another delimiting sidewall of the through hole 114 and the conductive pin 116. Even if the at least partially conductive pin 116 is misaligned with the respect to the stack 102 and in particular with the inorganic carrier 108, a reliable electrical connection may be ensured.

It should be noted that the term "comprising" does not exclude other elements or steps and the "a" or "an" does not exclude a plurality. Also, elements described in association with different embodiments may be combined.

It should also be noted that reference signs in the claims shall not be construed as limiting the scope of the claims.

Implementation of the invention is not limited to the preferred embodiments shown in the figures and described above. Instead, a multiplicity of variants is possible which use the solutions shown and the principle according to the invention even in the case of fundamentally different embodiments.

## Claims

1. A component carrier (100), which comprises:
a stack (102) comprising at least one electrically conductive layer structure (104) and at least one electrically insulating layer structure (106);
an inorganic carrier (108) provided as part of the stack (102), wherein said inorganic carrier (108) has a first main surface (110) and an opposing second main surface (112);
a through hole (114) in the inorganic carrier (108) extending between the first main surface (110) and the second main surface (112); and
at least one at least partially conductive pin (116) in said through hole (114);
wherein said at least one at least partially conductive pin (116) is directly encapsulated in the through hole (114) by encapsulating material (118) of at least one electrically insulating layer structure (106) of the stack (102).

2. The component carrier (100) according to claim 1, wherein the at least one at least partially conductive pin (116) comprises two extremities at least one of which being aligned with an assigned one of the first main surface (110) and the second main surface (112) of the inorganic carrier (108), in particular wherein the other of the two extremities is misaligned with the other assigned one of the first main surface (110) and the second main surface (112) of the inorganic carrier (108).

3. The component carrier (100) according to any of claims 1 to 2, wherein the at least one at least partially conductive pin (116) is misaligned with respect to a thickness direction (120) of the stack (102).

4. The component carrier (100) according to any of claims 1 to 3, wherein a plurality of through holes (114) are provided in the inorganic carrier (108) each extending between the first main surface (110) and the second main surface (112) and each having at least one at least partially conductive pin (116) in the respective through hole (114), wherein a first distance between two opposing extremities of a first one of the conductive pins (116) is different from a second distance between two opposing extremities of a second one of the conductive pins (116).

5. The component carrier (100) according to any of claims 1 to 4, wherein the at least one at least partially conductive pin (116) comprises a conductive core (124) having sidewalls being at least partially covered by a shell (126).

6. The component carrier (100) according to any of claims 1 to 5, comprising a shielding structure in the through hole (114).

7. The component carrier (100) according to claim 6, wherein the shielding structure is composed of at least two sub-structures, in particular wherein the at least two sub-structures are made of the same material or are made of different materials.

8. The component carrier (100) according to any of claims 1 to 7, wherein the stack (102) comprises at least one redistribution structure (130) on the first main surface (110) and/or the second main surface (112) of the inorganic carrier (108), in particular wherein the at least one redistribution structure (130) is electrically coupled with at least one extremity of the at least one at least partially conductive pin (116).

9. The component carrier (100) according to any of claims 1 to 8, wherein the encapsulating material (118) forms at least part of a surface finish layer.

10. The component carrier (100) according to any of claims 1 to 9, wherein the through hole (114) has tapering sidewalls, vertical sidewalls, or an hourglass shape.

11. The component carrier (100) according to any of claims 1 to 10, wherein the at least one at least partially conductive pin (116) is an inlay.

12. The component carrier (100) according to any of claims 1 to 11, comprising at least one non-conductive structure in said through hole (114).

13. The component carrier (100) according to any of claims 1 to 12, wherein a ratio between a vertical thickness (L) and a horizontal diameter (D) of the at least one at least partially conductive pin (116) is at least 2, in particular at least 3.

14. A method of manufacturing a component carrier (100), wherein the method comprises:
providing a stack (102) comprising at least one electrically conductive layer structure (104) and at least one electrically insulating layer structure (106);
providing an inorganic carrier (108) as part of the stack (102), wherein said inorganic carrier (108) has a first main surface (110) and an opposing second main surface (112);
forming a through hole (114) in the inorganic carrier (108) extending between the first main surface (110) and the second main surface (112);
inserting at least one at least partially conductive pin (116) in said through hole (114); and
directly encapsulating said at least one at least partially conductive pin (116) in the through hole (114) by encapsulating material (118) of at least one electrically insulating layer structure (106) of the stack (102).

15. The method according to claim 14, wherein the method comprises closing the through hole (114) by a temporary carrier (140), inserting the at least one at least partially conductive pin (116) in said through hole (114) and on said temporary carrier (140), thereafter carrying out said directly encapsulating, and removing the temporary carrier (140) after said directly encapsulating.
